# EUROPEAN PATENT APPLICATION

(11) **EP 4 693 385 A1**
(43) Date of publication of application: **11.02.2026**
(21) Application number: 24780005.5
(22) Date of filing: 22.03.2024
(51) Int. Cl.: H01L 21/677, H01L 21/304

(54) **SUBSTRATE PROCESSING MODULE AND SUBSTRATE PROCESSING DEVICE**

(30) Priority: 31.03.2023 JP 2023057731
(71) Applicant: Daikin Finetech, Ltd., Yamatokoriyama-shi, Nara 639-1031 (JP)
(72) Inventor: DEGUCHI, Yasunori, Yamatokoriyama-shi, Nara 639-1031 (JP); TOYOTAMA, Hidefumi, Yamatokoriyama-shi, Nara 639-1031 (JP)
(74) Representative: Eisenführ Speiser
(86) International application number: PCT/JP2024/011370
(87) International publication number: WO 2024/203887

(57) **Abstract**

A substrate processing module and a substrate processing module include: a first tank and a second tank that are arranged in a first direction and in which a substrate can be disposed; a first conveyance mechanism that moves the substrate in the first direction; and a second conveyance mechanism that moves the substrate in a second direction intersecting the first direction, wherein the first tank and the second tank are disposed in a first region, the first conveyance mechanism conveys the substrate in the first direction in a second region disposed above the first region, and the second conveyance mechanism conveys the substrate in the second direction in a third region different from the second region.

## Description

### TECHNICAL FIELD

The present disclosure relates to a substrate processing module that processes a substrate and a substrate processing device including the substrate processing module.

### BACKGROUND ART

As a substrate processing device, there is a cleaning device that processes various substrates (hereinafter, referred to as a "substrate") such as a semiconductor wafer with a predetermined chemical liquid, and then cleans the substrate with a cleaning liquid such as pure water to remove foreign matters adhering to a surface of the substrate. As the cleaning device, there is a wet-type cleaning device that performs a cleaning treatment by immersing the substrate in chemical liquid and cleaning liquid.

Patent Document 1 discloses a substrate processing device in which a plurality of pairs of a chemical liquid tank and a cleaning tank are disposed in a long-side direction of the device, and a main conveyance mechanism and a sub-conveyance mechanism are included. The main conveyance mechanism moves a plurality of substrates in the long-side direction from one end side to the other end side of the device. The sub-conveyance mechanism moves the plurality of substrates in the long-side direction and a vertical direction within a range of the pair of chemical liquid tank and the cleaning tank.

### PRIOR ART DOCUMENT

### PATENT DOCUMENT

Patent Document 1: JP-A-2018-56158

### SUMMARY OF THE INVENTION

### PROBLEMS TO BE SOLVED BY THE INVENTION

In the substrate processing device of Patent Document 1, there is a possibility that the main conveyance mechanism and the sub-conveyance mechanism interfere with each other when moving, and there is a possibility that throughput is reduced due to restriction in the moving order.

Therefore, an object of the present disclosure is to provide a substrate processing module and a substrate processing device capable of improving throughput.

### SOLUTIONS TO THE PROBLEMS

In order to achieve the object, a substrate processing module according to an aspect of the present disclosure includes: a first tank and a second tank that are arranged in a first direction and in which a substrate can be disposed; a first conveyance mechanism that moves the substrate in the first direction; and a second conveyance mechanism that moves the substrate in a second direction intersecting the first direction, in which the first tank and the second tank are disposed in a first region, the first conveyance mechanism conveys the substrate in the first direction in a second region disposed above the first region, and the second conveyance mechanism conveys the substrate in the second direction in a third region different from the second region.

A substrate processing device according to an aspect of the present disclosure includes the substrate processing module, and another module coupled to the substrate processing module in the second direction.

### EFFECTS OF THE INVENTION

According to the present disclosure, throughput can be improved.

### BRIEF DESCRIPTION OF THE DRAWINGS

[Fig. 1] Fig. 1 is a perspective view illustrating a substrate processing device according to a first embodiment.
[Fig. 2] Fig. 2 is a perspective view illustrating components of the substrate processing device illustrated in Fig. 1.
[Fig. 3] Fig. 3 is a perspective view illustrating a chemical module in the substrate processing device illustrated in Fig. 1.
[Fig. 4] Fig. 4 is a perspective view illustrating a second conveyance mechanism in the substrate processing device illustrated in Fig. 1.
[Fig. 5] Fig. 5 is a perspective view illustrating a main part of the chemical module illustrated in Fig. 3.
[Fig. 6] Fig. 6 is a perspective view illustrating an unloading module in the substrate processing device illustrated in Fig. 1.
[Fig. 7] Fig. 7 is a perspective view illustrating a loading module in the substrate processing device illustrated in Fig. 1.
[Fig. 8] Fig. 8 is a diagram illustrating the movement of a vertical conveyance section of the second conveyance mechanism in the chemical module illustrated in Fig. 3.
[Fig. 9] Fig. 9 is a diagram illustrating the movement of a first conveyance section of a first conveyance mechanism in the chemical module illustrated in Fig. 3.
[Fig. 10] Fig. 10 is a diagram illustrating a carrier that holds a substrate.
[Fig. 11] Fig. 11 is a perspective view illustrating a drying module in the substrate processing device illustrated in Fig. 1.
[Fig. 12] Fig. 12 is a schematic diagram of the second conveyance mechanism as viewed from a front.
[Fig. 13] Fig. 13 is a schematic plan view illustrating a treatment space according to a modification.
[Fig. 14A] Fig. 14A is a schematic diagram for illustrating an example of the operation of the substrate processing device.
[Fig. 14B] Fig. 14B is a schematic diagram for illustrating an example of the operation of the substrate processing device.
[Fig. 15A] Fig. 15A is a schematic diagram for illustrating an example of the operation of the substrate processing device.
[Fig. 15B] Fig. 15B is a schematic diagram for illustrating an example of the operation of the substrate processing device.
[Fig. 16A] Fig. 16A is a schematic diagram for illustrating an example of the operation of the substrate processing device.
[Fig. 16B] Fig. 16B is a schematic diagram for illustrating an example of the operation of the substrate processing device.
[Fig. 17A] Fig. 17A is a schematic diagram for illustrating an example of the operation of the substrate processing device.
[Fig. 17B] Fig. 17B is a schematic diagram for illustrating an example of the operation of the substrate processing device.
[Fig. 18A] Fig. 18A is a schematic diagram for illustrating an example of the operation of the substrate processing device.
[Fig. 18B] Fig. 18B is a schematic diagram for illustrating an example of the operation of the substrate processing device.
[Fig. 19A] Fig. 19A is a schematic diagram for illustrating an example of the operation of the substrate processing device.
[Fig. 19B] Fig. 19B is a schematic diagram for illustrating an example of the operation of the substrate processing device.
[Fig. 20A] Fig. 20A is a schematic diagram for illustrating an example of the operation of the substrate processing device.
[Fig. 20B] Fig. 20B is a schematic diagram for illustrating an example of the operation of the substrate processing device.
[Fig. 21A] Fig. 21A is a schematic diagram for illustrating an example of the operation of the substrate processing device.
[Fig. 21B] Fig. 21B is a schematic diagram for illustrating an example of the operation of the substrate processing device.
[Fig. 22A] Fig. 22A is a schematic diagram for illustrating an example of the operation of the substrate processing device.
[Fig. 22B] Fig. 22B is a schematic diagram for illustrating an example of the operation of the substrate processing device.
[Fig. 23A] Fig. 23A is a schematic diagram for illustrating an example of the operation of the substrate processing device.
[Fig. 23B] Fig. 23B is a schematic diagram for illustrating an example of the operation of the substrate processing device.
[Fig. 24A] Fig. 24A is a schematic diagram for illustrating an example of the operation of the substrate processing device.
[Fig. 24B] Fig. 24B is a schematic diagram for illustrating an example of the operation of the substrate processing device.
[Fig. 25A] Fig. 25A is a schematic diagram for illustrating an example of the operation of the substrate processing device.
[Fig. 25B] Fig. 25B is a schematic diagram for illustrating an example of the operation of the substrate processing device.
[Fig. 26A] Fig. 26A is a schematic diagram for illustrating an example of the operation of the substrate processing device.
[Fig. 26B] Fig. 26B is a schematic diagram for illustrating an example of the operation of the substrate processing device.
[Fig. 27] Fig. 27 is a schematic plan view showing an operation example in a case where a substrate is processed in one batch.
[Fig. 28] Fig. 28 is a schematic plan view showing an operation example in a case where a substrate is processed in a plurality of batches.
[Fig. 29] Fig. 29 is a schematic diagram showing a state in which a substrate is disposed in each of a plurality of chemical modules in the substrate processing device according to the first embodiment.
[Fig. 30] Fig. 30 is a schematic diagram showing a state in which a substrate is disposed in each of a plurality of chemical modules in a substrate processing device according to a second embodiment.
[Fig. 31] Fig. 31 is a schematic plan view showing movement ranges of the first conveyance mechanism and the second conveyance mechanism in the substrate processing device according to the first embodiment.
[Fig. 32] Fig. 32 is a schematic plan view showing movement ranges of a first conveyance mechanism and a second conveyance mechanism in a substrate processing device according to a third embodiment.
[Fig. 33] Fig. 33 is a schematic perspective view showing a first conveyance mechanism in a substrate processing device according to a fourth embodiment.
[Fig. 34] Fig. 34 is a schematic front view showing a transfer state of a substrate by two first conveyance sections in the substrate processing device according to the fourth embodiment.
[Fig. 35A] Fig. 35A is a schematic plan view showing a transfer operation of a substrate by the two first conveyance sections in the substrate processing device according to the fourth embodiment.
[Fig. 35B] Fig. 35B is a schematic plan view showing a transfer operation of a substrate by the two first conveyance sections in the substrate processing device according to the fourth embodiment.
[Fig. 35C] Fig. 35C is a schematic plan view showing a transfer operation of a substrate by the two first conveyance sections in the substrate processing device according to the fourth embodiment.
[Fig. 35D] Fig. 35D is a schematic plan view showing a transfer operation of a substrate by the two first conveyance sections in the substrate processing device according to the fourth embodiment.
[Fig. 36] Fig. 36 is a schematic front view showing a peripheral structure of a second conveyance mechanism in a substrate processing device according to a fifth embodiment.
[Fig. 37] Fig. 37 is a schematic side view showing the peripheral structure of the second conveyance mechanism in the substrate processing device according to the fifth embodiment.
[Fig. 38] Fig. 38 is a schematic perspective view of a chuck portion according to the fifth embodiment.
[Fig. 39] Fig. 39 is a schematic plan view of the chuck portion according to the fifth embodiment.
[Fig. 40] Fig. 40 is a schematic plan view of a first conveyance mechanism according to the fifth embodiment.
[Fig. 41] Fig. 41 is a schematic plan view of the first conveyance mechanism according to the fifth embodiment.
[Fig. 42] Fig. 42 is a schematic front view of the first conveyance mechanism according to the fifth embodiment.
[Fig. 43A] Fig. 43A is a schematic front view showing a transfer method of a substrate between two first conveyance sections according to the fifth embodiment.
[Fig. 43B] Fig. 43B is a schematic front view showing a transfer method of a substrate between the two first conveyance sections according to the fifth embodiment.
[Fig. 43C] Fig. 43C is a schematic front view showing a transfer method of a substrate between the two first conveyance sections according to the fifth embodiment.
[Fig. 44A] Fig. 44A is a schematic front view showing a transfer method of a substrate from a second conveyance section to the first conveyance section according to the fifth embodiment.
[Fig. 44B] Fig. 44B is a schematic front view showing a transfer method of a substrate from the second conveyance section to the first conveyance section according to the fifth embodiment.
[Fig. 44C] Fig. 44C is a schematic front view showing a transfer method of a substrate from the second conveyance section to the first conveyance section according to the fifth embodiment.
[Fig. 45A] Fig. 45A is a schematic front view showing a transfer method of a substrate from the first conveyance section to the second conveyance section according to the fifth embodiment.
[Fig. 45B] Fig. 45B is a schematic front view showing a transfer method of a substrate from the first conveyance section to the second conveyance section according to the fifth embodiment.
[Fig. 45C] Fig. 45C is a schematic front view showing a transfer method of a substrate from the first conveyance section to the second conveyance section according to the fifth embodiment.
[Fig. 45D] Fig. 45D is a schematic front view showing a transfer method of a substrate from the first conveyance section to the second conveyance section according to the fifth embodiment.
[Fig. 46A] Fig. 46A is a schematic side view showing a state in which the chuck portion according to the fifth embodiment is slid in a +Y direction.
[Fig. 46B] Fig. 46B is a schematic side view showing a state in which the chuck portion according to the fifth embodiment is slid in a -Y direction.
[Fig. 47] Fig. 47 is a schematic side view showing a peripheral structure of a second conveyance mechanism in a substrate processing device according to a modification of the fifth embodiment.
[Fig. 48] Fig. 48 is a schematic plan view showing variations of a first tank and a second tank.

### DETAILED DESCRIPTION

According to a first aspect of the present disclosure, there is provided a substrate processing module including: a first tank and a second tank that are arranged in a first direction and in which a substrate can be disposed; a first conveyance mechanism that moves the substrate in the first direction; and a second conveyance mechanism that moves the substrate in a second direction intersecting the first direction, in which the first tank and the second tank are disposed in a first region, the first conveyance mechanism conveys the substrate in the first direction in a second region disposed above the first region, and the second conveyance mechanism conveys the substrate in the second direction in a third region different from the second region.

According to a second aspect of the present disclosure, there is provided the substrate processing module according to the first aspect, in which the first region, the second region, and the third region are disposed in this order from a bottom in a vertical direction.

According to a third aspect of the present disclosure, there is provided the substrate processing module according to the second aspect, in which the first conveyance mechanism includes a first vertical actuator that vertically moves the substrate between the first region and the second region, and the second conveyance mechanism includes a second vertical actuator that vertically moves the substrate between the second region and the third region.

According to a fourth aspect of the present disclosure, there is provided the substrate processing module according to the third aspect, in which the first vertical actuator is disposed at a position shifted in the second direction with respect to the first tank and the second tank and disposed at a height position lower than the second region.

According to a fifth aspect of the present disclosure, there is provided the substrate processing module according to any one of the first to fourth aspects, further including a controller, in which the controller controls the first conveyance mechanism and the second conveyance mechanism to transfer the substrate with each other in the second region.

According to a sixth aspect of the present disclosure, there is provided the substrate processing module according to the fifth aspect, further including a controller, in which the controller controls the second conveyance mechanism to selectively execute a first function of conveying the substrate in the second direction in the second region and a second function of conveying the substrate in the second direction in the third region.

According to a seventh aspect of the present disclosure, there is provided the substrate processing module according to any one of the second to fourth aspects, in which a movement range of the substrate in the first direction by the first conveyance mechanism and a movement range of the substrate in the second direction by the second conveyance mechanism overlap each other in plan view.

According to an eighth aspect of the present disclosure, there is provided the substrate processing module according to any one of the first to seventh aspects, in which two of the first conveyance sections are provided, one of the first conveyance sections includes a first chuck that is movable vertically and is disposed in the first tank in a state of holding a substrate, another of the first conveyance sections includes a second chuck that is movable vertically and is disposed in the second tank in a state of holding a substrate, at least one of the first chuck and the second chuck is movable between an upper position of the first tank and an upper position of the second tank, and the first chuck and the second chuck are configured to be able to transfer a substrate to each other.

According to a ninth aspect of the present disclosure, there is provided the substrate processing module according to any one of the first to eighth aspects, in which the first tank is disposed on a front side in the first direction, the second tank is disposed on a rear side in the first direction, and the second conveyance mechanism moves the substrate above the first tank.

According to a tenth aspect of the present disclosure, there is provided the substrate processing module according to any one of the first to ninth aspects, in which each of the first tank and the second tank is any one of a chemical liquid tank that treats the substrate with chemical liquid, a cleaning tank that cleans the substrate, and a one-bath treatment tank having a function of treating the substrate with chemical liquid and a function of cleaning the substrate.

According to an eleventh aspect of the present disclosure, there is provided the substrate processing module according to the tenth aspect, in which the first tank is a cleaning tank disposed on a front side in the first direction, and the second tank is a chemical liquid tank disposed on a rear side in the first direction.

According to a twelfth aspect of the present disclosure, there is provided the substrate processing module according to any one of the first to eleventh aspects, in which the substrate processing module can be coupled to another module in the second direction, and the another module is any one of a loading module, an unloading module, a drying module, and a substrate processing module.

According to a thirteenth aspect of the present disclosure, there is provided the substrate processing module according to any one of the first to twelfth aspects, in which the first conveyance mechanism or the second conveyance mechanism includes a position adjustment mechanism that adjusts a position of holding the substrate.

According to a fourteenth aspect of the present disclosure, there is provided the substrate processing module according to the thirteenth aspect, in which the position adjustment mechanism has a function of adjusting a conveyance position of the substrate in the first direction.

According to a fifteenth aspect of the present disclosure, there is provided a substrate processing device including: the substrate processing module according to any one of the first to fourteenth aspects; and another module coupled to the substrate processing module in the second direction.

Hereinafter, an embodiment of a substrate processing device 1 according to the present invention will be described with reference to the drawings.

Note that, in the present specification, the "module" means a component that is standardized and configured to be detachable (replaceable), and is handled as one collective constituent unit when used. Furthermore, the "first direction" means a direction in which a pair of a chemical liquid tank and a cleaning tank is arranged, that is, a short-side direction (for example, in a front-rear direction or a longitudinal direction) of the substrate processing device 1. Furthermore, the "second direction" is a direction intersecting the first direction and the vertical direction, and means a direction in which a plurality of modules is continuously provided, that is, a long-side direction (for example, a left-right direction or a lateral direction) of the substrate processing device 1. The first direction may be referred to as a transverse direction (TD), and the second direction may be referred to as a machine direction (MD). In the drawing, the "first direction" is illustrated as a Y-axis direction, the "second direction" is illustrated as an X-axis direction, and the "vertical direction" is illustrated as a Z-axis direction. The first direction, the second direction, and the vertical direction intersect each other (for example, are orthogonal to each other).

### [First Embodiment]

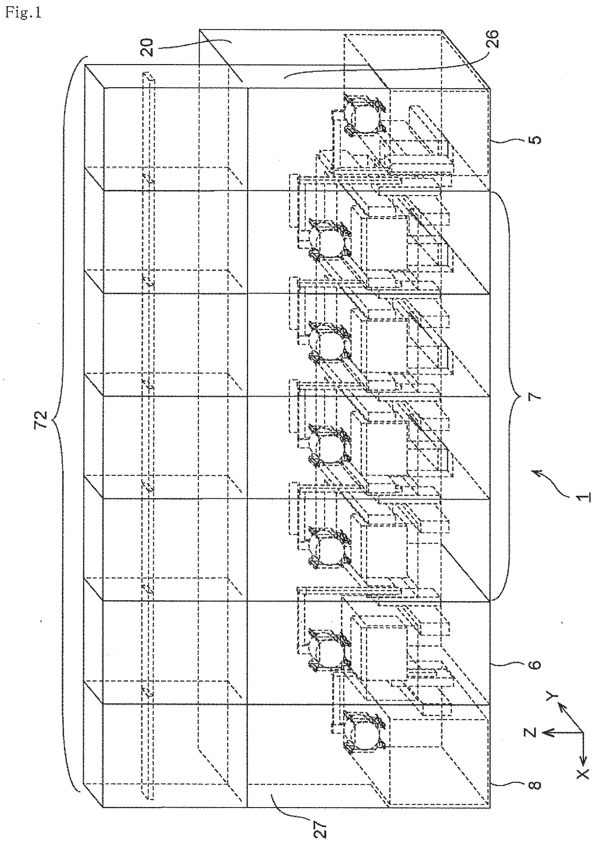

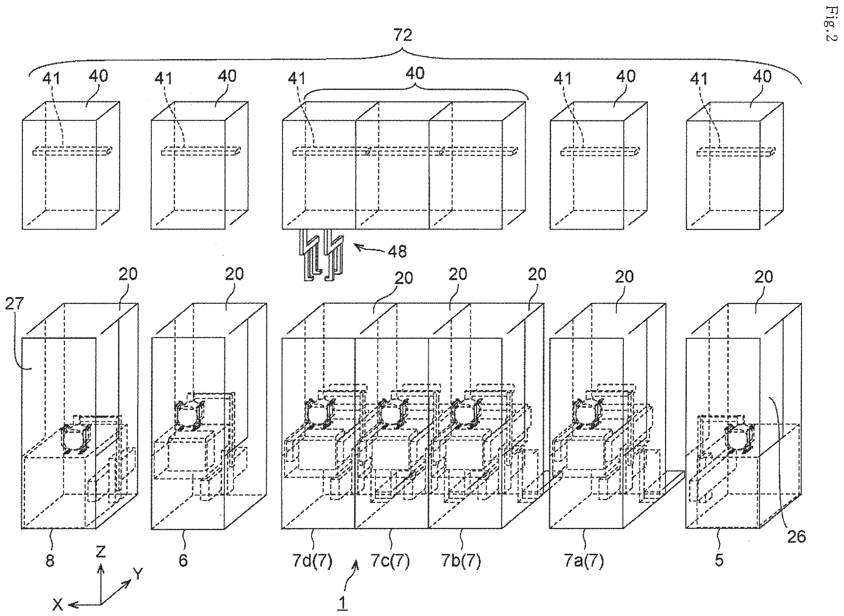

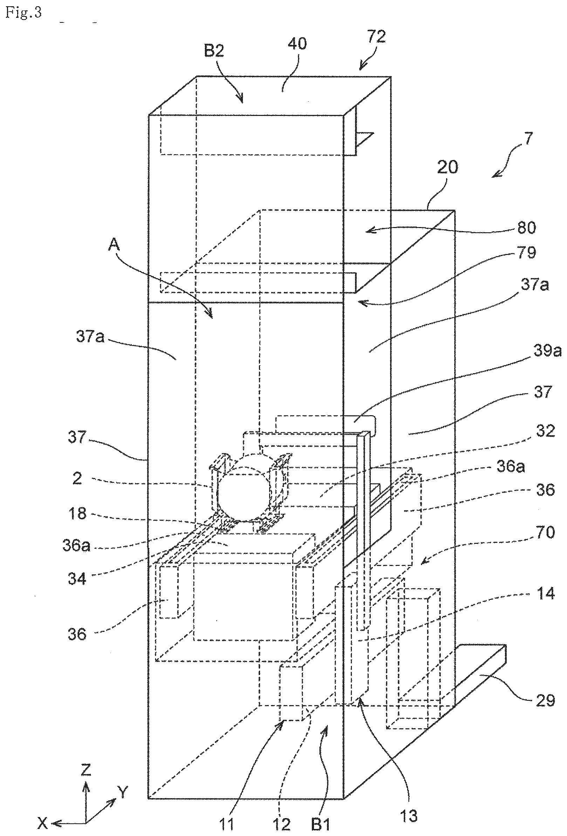

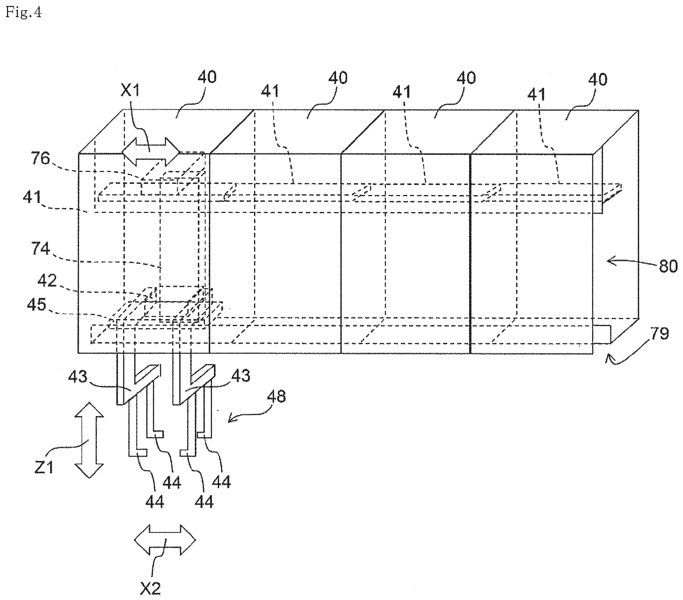

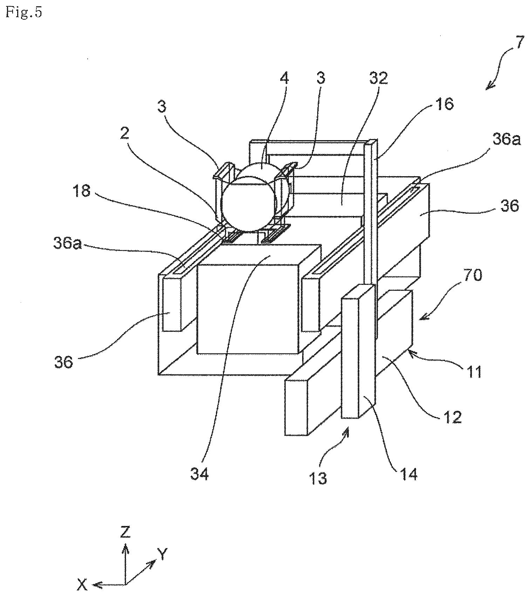

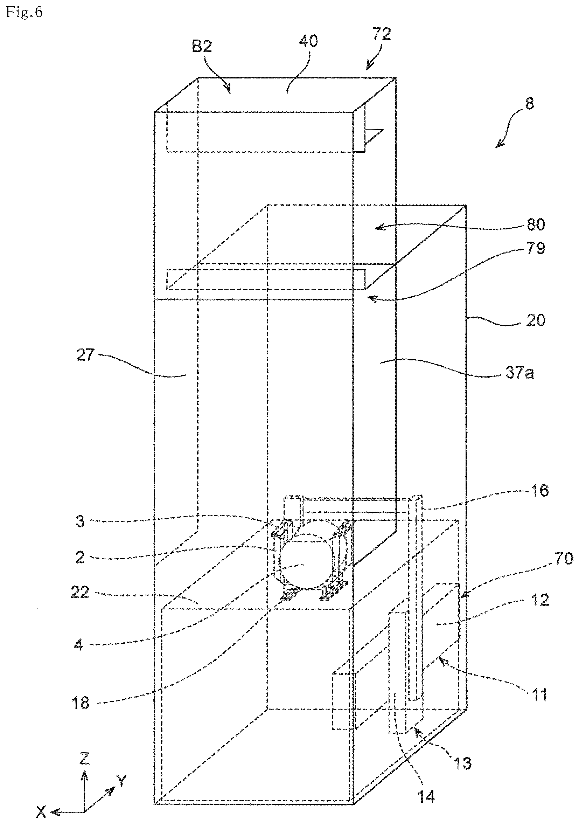

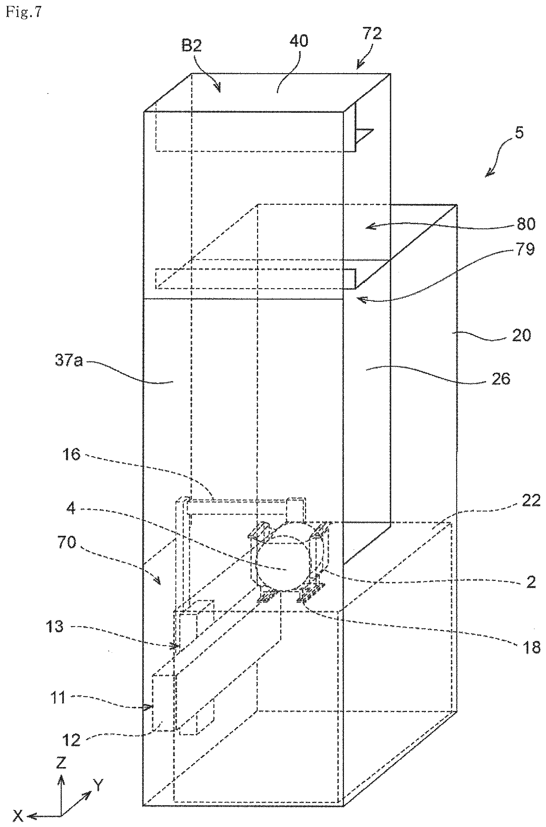

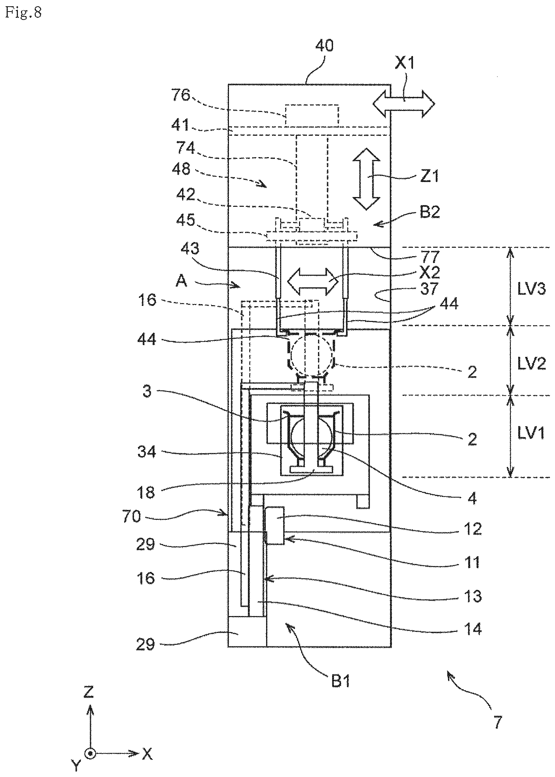

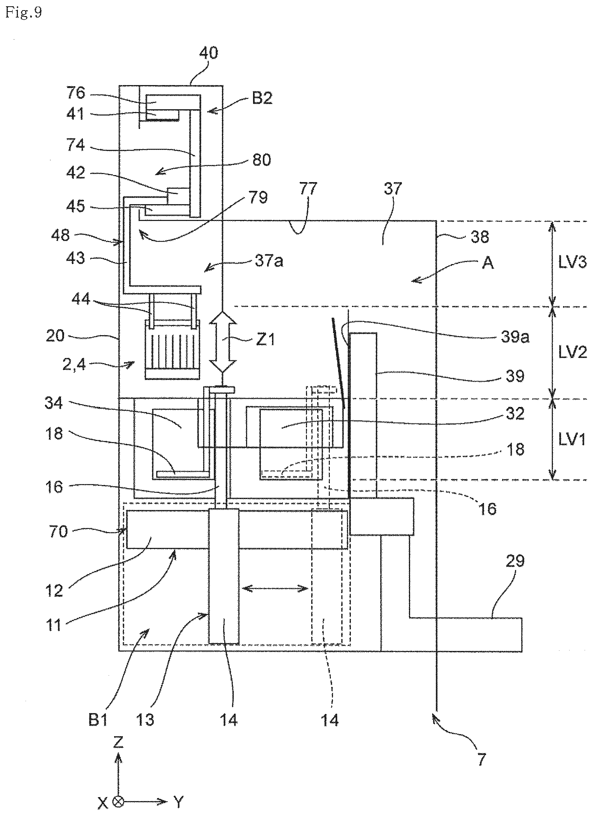

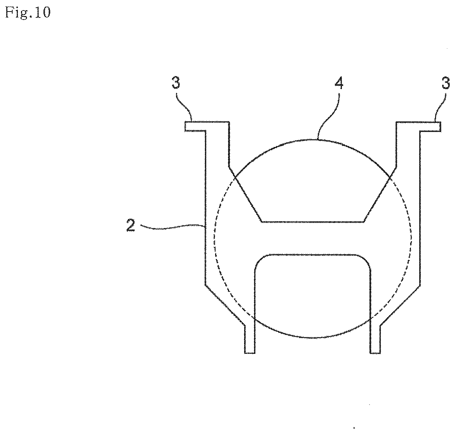

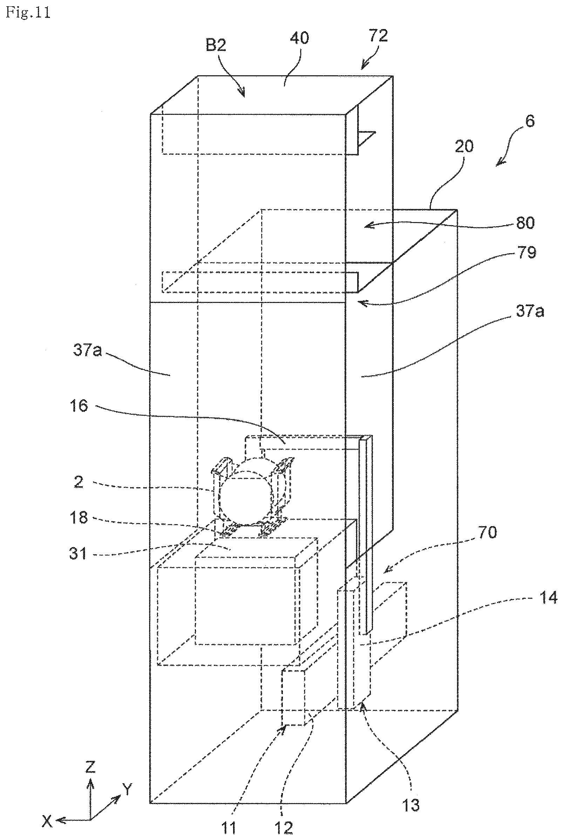

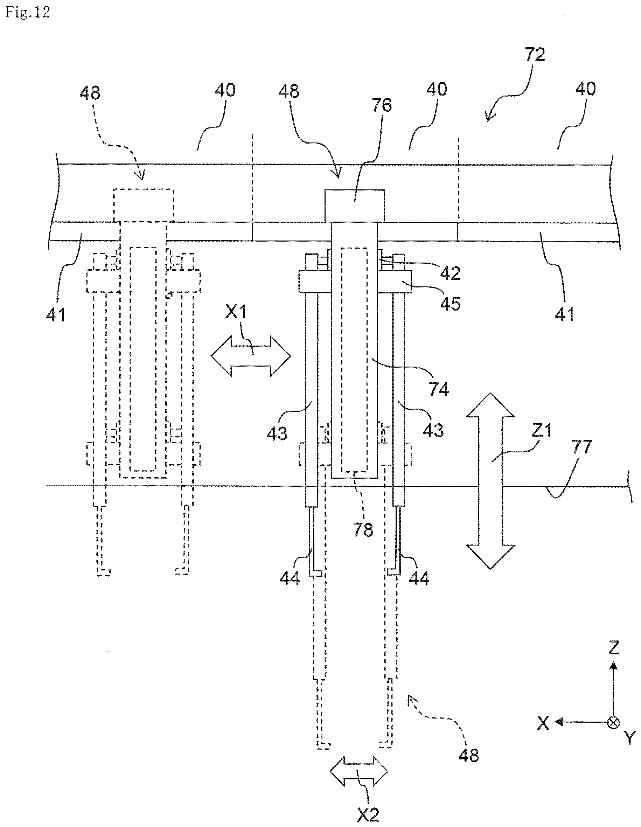

A substrate processing device 1 according to a first embodiment will be described with reference to Figs. 1 to 10. Fig. 1 is a perspective view illustrating a substrate processing device 1 according to a first embodiment. Fig. 2 is a perspective view illustrating components of the substrate processing device 1 illustrated in Fig. 1. Fig. 3 is a perspective view illustrating a chemical module 7 in the substrate processing device 1 illustrated in Fig. 1. Fig. 4 is a perspective view illustrating the second conveyance mechanism 72 in the substrate processing device 1 illustrated in Fig. 1. Fig. 5 is a perspective view illustrating a main part of the chemical module 7 illustrated in Fig. 3. Fig. 6 is a perspective view illustrating an unloading module 8 in the substrate processing device 1 illustrated in Fig. 1. Fig. 7 is a perspective view illustrating a loading module 5 in the substrate processing device 1 illustrated in Fig. 1. Fig. 8 is a diagram illustrating the movement of a vertical conveyance section 13 of a second conveyance mechanism 72 in the chemical module 7 illustrated in Fig. 3. Fig. 9 is a diagram illustrating the movement of a first conveyance section 11 of a first conveyance mechanism 70 in the chemical module 7 illustrated in Fig. 3. Fig. 10 is a diagram illustrating a carrier 2 that holds a substrate 4. Fig. 11 is a perspective view illustrating a drying module 6 in the substrate processing device 1 illustrated in Fig. 1. Fig. 12 is a schematic diagram of the second conveyance mechanism 72 illustrated in Fig. 4 as viewed from the front.

The substrate processing device 1 includes, for example, at least one module for performing various types of processing on a plurality of the substrates 4 held by the carrier 2. The substrate 4 is, for example, a semiconductor substrate, a glass substrate for a liquid crystal display device, a glass substrate for a photomask, a substrate for an optical disk, a MEMS sensor substrate, a panel for a solar cell, or the like. The module has a standardized casing 20, and is configured to be detachable (replaceable) in the second direction (the X-axis direction is the long-side direction of the substrate processing device 1, and is hereinafter referred to as "second direction"). A fan filter unit (not illustrated) may be provided on top of the module. The fan filter unit includes a fan and a filter for taking in air in a clean room and sending the air into the module. The fan filter unit creates a clean air downflow in the processing space within the module. Instead of providing a fan filter unit, another configuration that takes in clean air in the clean room can be used.

As illustrated in Figs. 1 and 2, the substrate processing device 1 includes, for example, the loading module 5, the drying module 6, the chemical module 7 (substrate processing module), the unloading module 8, and the second conveyance mechanism 72. The loading module 5, the chemical module 7, the drying module 6, and the unloading module 8 are provided adjacent to each other along the second direction. The loading module 5, the chemical module 7, the drying module 6, and the unloading module 8 are configured to be detachably coupled in the second direction. Therefore, it is possible to flexibly respond to the need for changing the processing process, and the expandability is enhanced. Note that a transparent window that can be visually recognized by an operator may be provided on the front surface side of the substrate processing device 1.

The second conveyance mechanism 72 extends in the second direction and conveys the carrier 2 holding the plurality of substrates 4 illustrated in Fig. 10 in the second direction. The second conveyance mechanism 72 is provided in an upper portion on the front side in the first direction (Y-axis direction, which is the short-side direction of the substrate processing device 1, hereinafter, referred to as "first direction") of the loading module 5, the chemical module 7, the drying module 6, and the unloading module 8.

The substrate processing device 1 further includes a first conveyance mechanism 70 as illustrated in Figs. 3, 5 to 9, and 11. The first conveyance mechanism 70 has a function of conveying the carrier 2 holding the plurality of substrates 4 in the vertical direction and the first direction and immersing the substrates 4 in each of the chemical liquid tank 32 and the cleaning tank 34. The first conveyance mechanism 70 includes a first conveyance section 11 described later, a first actuator 12, a vertical conveyance section 13, a vertical actuator 14, an arm 16, and a pedestal 18.

The first conveyance mechanism 70 and the second conveyance mechanism 72 can transfer the carrier 2 to each other. A specific method will be described later.

The substrate processing device 1 includes a controller 101 schematically illustrated in Fig. 1. The controller 101 performs, for example, operation control and data calculation of each element of the substrate processing device 1. The controller 101 includes, for example, a central processing unit (CPU), a random access memory (RAM), and a read only memory (ROM). The CPU executes control (for example, control such as conveyance operation of the carrier 2 by the first conveyance mechanism 70 and the second conveyance mechanism 72) according to a program stored in the ROM.

In the loading module 5, the substrate 4 before processing is loaded into the device with the carrier 2 as one unit. In the drying module 6, for example, vapor drying of the substrate 4 by isopropyl alcohol (IPA) or the like is performed using the carrier 2 as one unit. In the chemical module 7, the cleaning treatment of the substrate 4 is executed using the carrier 2 as one unit. In the unloading module 8, the substrate 4 after the cleaning treatment is carried to the outside of the device using the carrier 2 as one unit.

The loading module 5 is also called a loader section, and is provided on the upstream side in the second direction of the substrate processing device 1. As illustrated in Fig. 7, the loading module 5 includes a loading section 26 configured to be openable and closeable on an upstream side surface of the casing 20 in the second direction. The carrier 2 is loaded into the loading module 5 via the loading section 26. The carrier 2 carried into the loading module 5 is placed on a placement table 22. In the loading module 5, the conveyance of the carrier 2 in the first direction is performed by the first conveyance section 11 via the arm 16, and the conveyance of the carrier 2 in the vertical direction is performed by the vertical conveyance section 13 via the arm 16. A second conveyance and accommodation section 40 of the second conveyance mechanism 72 is placed on an upper portion of the casing 20 of the loading module 5. The carrier 2 is conveyed in the second direction by the second conveyance section 48 (not illustrated), and is conveyed to the downstream side through an opening 37a provided at a position facing the loading section 26. The first actuator 12 of the first conveyance section 11 is disposed to the side of and in a lower portion than the placement surface of the placement table 22. The vertical actuator 14 of the vertical conveyance section 13 is also disposed to the side of and in a lower portion than the placement surface of the placement table 22. That is, due to the downflow from the fan filter unit and the arm length of the arm 16, the carrier 2 placed on the placement table 22 is isolated so as not to be affected by the first actuator 12 and the vertical actuator 14. Therefore, it is possible to suppress contamination of the carrier 2 in the loading module 5 due to particles generated from the first actuator 12 and the vertical actuator 14.

The unloading module 8 is also referred to as an unloader section, and is provided on the downstream side in the second direction of the substrate processing device 1. As illustrated in Fig. 6, the carrier 2 loaded into the unloading module 8 is placed on the placement table 22. In the inside of the unloading module 8, the conveyance of the carrier 2 in the first direction is performed by the first conveyance section 11 via the arm 16, and the conveyance of the carrier 2 in the vertical direction is performed by the vertical conveyance section 13 via the arm 16. The first actuator 12 of the first conveyance section 11 is disposed to the side of and in a lower portion than the placement surface of the placement table 22. The vertical actuator 14 of the vertical conveyance section 13 is also disposed to the side of and in a lower portion than the placement surface of the placement table 22. That is, due to the downflow from the fan filter unit and the arm length of the arm 16, the carrier 2 placed on the placement table 22 is isolated so as not to be affected by the first actuator 12 and the vertical actuator 14. Therefore, it is possible to suppress contamination of the carrier 2 in the unloading module 8 due to particles generated from the first actuator 12 and the vertical actuator 14. The unloading module 8 includes an unloading section 27 configured to be openable and closeable on a side surface on the downstream side in the second direction of the casing 20. The carrier 2 is carried to the outside of the unloading module 8, that is, to the outside of the substrate processing device 1 via the unloading section 27. The second conveyance and accommodation section 40 of the second conveyance mechanism 72 is placed on the upper portion of the casing 20 of the unloading module 8. The carrier 2 is conveyed in the second direction by the second conveyance section 48 (not illustrated), and is carried into the unloading module 8 through the opening 37a provided at a position facing the unloading section 27.

Note that, in the above aspect, the carrier 2 is conveyed in one direction along the second direction from the loading module 5 toward the unloading module 8, but another aspect may be adopted. For example, the substrate processing device 1 may include only one of the loading module 5 and the unloading module 8, and the loading module 5 may have functions of both a loader and an unloader, or the unloading module 8 may have functions of both a loader and an unloader. At this time, the carrier 2 is conveyed in both of one direction and the other direction along the second direction (that is, the carrier is reciprocated along the second direction).

The substrate processing device 1 includes at least one drying module 6. As illustrated in Fig. 1, the drying module 6 is installed, for example, between the chemical module 7 and the unloading module 8.

As illustrated in Fig. 11, for example, similarly to the other modules 5, 7, and 8, the drying module 6 includes, as the first conveyance mechanism 70, a first conveyance section 11 that conveys the carrier 2 in the first direction, and a vertical conveyance section 13 that conveys the carrier 2 in the vertical direction. The first conveyance section 11 includes a first actuator 12, and the vertical conveyance section 13 includes a vertical actuator 14. The second conveyance and accommodation section 40 of the second conveyance mechanism 72 is placed on the upper portion of the casing 20 of the drying module 6. The carrier 2 is conveyed in the second direction by the second conveyance section 48 (not illustrated), is carried into the drying module 6 through the upstream opening 37a (right side in Fig. 11) of the two openings 37a provided at positions facing each other, and is carried to the outside of the drying module 6 through the downstream opening 37a (left side in Fig. 11).

The drying module 6 includes a drying chamber 31. The drying chamber 31 is provided, for example, on the front side in the first direction in the drying module 6. A drying treatment for drying the substrate 4 after various chemical liquid treatments such as various chemical liquid cleaning, etching, and resist peeling are performed by the chemical module 7 is performed in the drying chamber 31. In the drying module 6, the carrier 2 holding the substrate 4 is conveyed in the vertical direction with respect to the drying chamber 31 by the vertical conveyance section 13 via the arm 16. The first actuator 12 and the vertical actuator 14 are disposed apart from the drying chamber 31 in a side lower portion of the drying chamber 31. Therefore, the drying chamber 31 is isolated so as not to be affected by the first actuator 12 and the vertical actuator 14.

In this drying treatment, a generally known drying method can be used. Specifically, for example, a drying method using Marangoni effect called IPA Mist Dryer (IMD) can be used. In this drying method, the carrier 2 holding the substrate 4 is immersed in a pure water tank provided in the drying chamber 31, a mist of IPA or vaporized IPA is continuously supplied to the water surface, and a difference in surface tension generated on the surface of the substrate 4 passing through the water surface is used when the substrate 4 is raised or lowered or the water surface is overflowed or down flowed.

Furthermore, as another drying method, for example, drying by centrifugal force called Spin Dryer can also be used. This drying method uses a centrifugal force generated by setting the carrier 2 holding the substrate 4 in a rotating rotor provided in the drying chamber 31, fixing the carrier 2 and the substrate 4 by a retaining device called a retainer, and then rotating the rotating rotor.

Furthermore, as another drying method, for example, drying by steam washing called vapor dryer can be used. In this drying method, the drying chamber 31 is filled with saturated vapor formed by heating a solvent having a small latent heat of evaporation (for example, IPA), the carrier 2 holding the substrate 4 at a temperature lower than the vapor temperature is set in the drying chamber 31, the surfaces of the carrier 2 and the substrate 4 are washed with IPA that aggregates and liquefies on the surface of the substrate 4, and when the carrier 2 and the substrate 4 are warmed to the same temperature as the IPA vapor, the aggregation and liquefaction of IPA on the surfaces of the carrier 2 and the substrate 4 is stopped, and the carrier 2 and the substrate 4 are dried.

As still another drying method, N₂ blow drying using N₂ can also be used. In any drying method, the drying chamber 31 is isolated so as not to be affected by the vertical actuator 14 and the first actuator 12 that convey the carrier 2 holding the substrate 4. Therefore, it is possible to suppress contamination in the drying module 6 due to particles generated from the vertical actuator 14 and the first actuator 12. Note that the first actuator 12 and the vertical actuator 14 may be disposed at a lower portion of the drying chamber 31 on the rear side in the first direction so as to be separated from the drying chamber 31. Furthermore, in the case where only the conveyance in the vertical direction is required, the drying module 6 may not include the first conveyance section 11.

The chemical module 7 includes at least one module. As illustrated in Figs. 1 and 2, the chemical module 7 includes, for example, a first chemical module 7a, a second chemical module 7b, a third chemical module 7c, and a fourth chemical module 7d. In the chemical module 7, various chemical liquid cleaning such as ammonium hydroxide-hydrogen peroxide mixture (APM) cleaning, sulfuric acid-hydrogen peroxide mixture (SPM) cleaning, hydrochloric acid-hydrogen peroxide mixture (HPM), and diluted hydrofluoric acid (DHF) cleaning, and various chemical liquid treatments such as etching and resist peeling are performed. These chemical liquid treatments can be arbitrarily combined depending on the types of chemical liquid treatments for the substrate 4. The chemical modules 7a, 7b, 7c, and 7d are configured to be detachably coupled in the second direction. Therefore, it is possible to flexibly respond to the need for changing the processing process, and the expandability is enhanced.

As illustrated in Figs. 3, 5, and 9, the chemical module 7 includes a chemical liquid tank 32 (second tank) for performing chemical liquid cleaning and a cleaning tank 34 (first tank) for performing pure water cleaning (rinsing). The chemical liquid tank 32 is provided on the rear side in the first direction, and the cleaning tank 34 is provided on the front side in the first direction. That is, the chemical liquid tank 32 and the cleaning tank 34 are arranged in the first direction. Therefore, since the width of the chemical module 7 in the second direction is narrowed, the substrate processing device 1 can be downsized. Note that the chemical liquid tank 32 may be provided on the front side in the first direction, and the cleaning tank 34 may be provided on the rear side in the first direction. Furthermore, since the common exhaust duct 29 for exhausting the chemical liquid vapor generated from the chemical liquid tank 32 can be provided on the rear side in the first direction, maintenance of the substrate processing device 1 becomes easy. The chemical liquid tank 32 stores the above-described various chemical liquids. Pure water is stored in the cleaning tank 34. The chemical liquid tank 32 includes, for example, an inner tank in which the carrier 2 is immersed in the chemical liquid, and an outer tank that recovers the chemical liquid overflowing from the upper end of the inner tank. At a timing not related to the conveyance operation of the carrier 2, an opening portion of the chemical liquid tank 32 is closed by a lid.

Two side walls 37, 37 are provided on the side of the chemical liquid tank 32 in the second direction. That is, the side of the chemical liquid tank 32 in the second direction is partitioned by the side wall 37. Therefore, it is possible to suppress contamination due to the atmosphere of the chemical liquid stored in the chemical liquid tank 32 of the chemical module 7 located adjacent thereto. At the same time, a rear wall 38 is provided behind the chemical liquid tank 32 in the first direction. The chemical liquid tank 32 is surrounded by the two side walls 37, 37 and the rear wall 38 in a U shape when viewed from the vertical direction.

For example, the two side exhaust ducts 36, 36 each having the side exhaust port 36a can be provided in the upper side of the chemical liquid tank 32. The two side exhaust ports 36a, 36a are slightly lower than the opening portion of the chemical liquid tank 32, but are located at substantially the same height. The rear wall 38 is provided with a rear exhaust port 39a of the rear exhaust duct 39 (illustrated in Fig. 9). The two side exhaust ducts 36, 36 and the rear exhaust duct 39 branch from the common exhaust duct 29 and are connected to the common exhaust duct 29. The rear exhaust port 39a is located above the opening portion of the chemical liquid tank 32. In this manner, the side exhaust port 36a and the rear exhaust port 39a for exhausting the chemical liquid vapor evaporated from the chemical liquid tank 32 are provided around the chemical liquid tank 32. Therefore, the chemical liquid vapor generated from the chemical liquid tank 32 can be suppressed from diffusing into the processing space in the chemical module 7, and contamination of the substrate 4 conveyed in the processing space in the chemical module 7 can be suppressed.

The first conveyance mechanism 70 of each chemical module 7 includes the first conveyance section 11 that conveys the carrier 2 in the first direction and the vertical conveyance section 13 that conveys the carrier 2 in the vertical direction. The vertical conveyance section 13 includes the vertical actuator 14. The carrier 2 is supported by the pedestal 18 provided on one end side of the arm 16 having an inverted U-shape. Note that the carrier 2 includes the flange portion 3 on the upper portion thereof, and as described later, the chuck portion 44 of the second conveyance section 48 enables the flange portion 3 to be gripped in a freely detachable manner. Furthermore, the flange portion 3 of the carrier 2 may be supported by the pedestal 18. Furthermore, the arm 16 can also have a D-shape.

The other end side of the arm 16 is attached to the vertical actuator 14. The vertical actuator 14 is an electric linear actuator, and includes, for example, a screw shaft that moves the arm 16, a motor that rotates the screw shaft, a power supply, and a controller that controls the motor. When the arm 16 is moved downward by the vertical actuator 14 in a state where the carrier 2 is positioned immediately above the chemical liquid tank 32 or the cleaning tank 34, the carrier 2 holding the plurality of substrates 4 is immersed in the chemical liquid in the chemical liquid tank 32 or the cleaning liquid in the cleaning tank 34. When the arm 16 is moved upward by the vertical actuator 14 in a state where the carrier 2 is immersed in the chemical liquid or the cleaning liquid, the carrier 2 holding the plurality of substrates 4 is pulled up from the chemical liquid or the cleaning liquid. Therefore, when the arm 16 is moved in the vertical direction by the vertical actuator 14 in a state where the carrier 2 is positioned immediately above the chemical liquid tank 32 or the cleaning tank 34, the carrier 2 holding the plurality of substrates 4 is pulled up or immersed in the chemical liquid in the chemical liquid tank 32 or the cleaning liquid in the cleaning tank 34.

The first conveyance section 11 includes the first actuator 12. The vertical actuator 14 is attached to the first actuator 12. The first actuator 12 is an electric linear actuator, and includes, for example, a screw shaft that moves the vertical actuator 14, a motor that rotates the screw shaft, a power supply, and a controller that controls the motor. When the arm 16 moves to the rear side in the first direction by the first actuator 12 in a state where the arm 16 has moved upward, the carrier 2 holding the plurality of substrates 4 is conveyed immediately above the chemical liquid tank 32. When the arm 16 is moved to the front side in the first direction by the first actuator 12 in a state where the arm 16 is positioned at a pull-up position, the carrier 2 holding the plurality of substrates 4 is conveyed immediately above the cleaning tank 34. Therefore, when the arm 16 is moved in the first direction by the first actuator 12 in a state where the arm 16 is positioned at the pull-up position, the carrier 2 holding the plurality of substrates 4 is conveyed between immediately above the chemical liquid tank 32 and immediately above the cleaning tank 34.

The first actuator 12 and the vertical actuator 14 are provided outside the opening portion of the chemical liquid tank 32 and in a side lower portion with the side exhaust duct 36 interposed therebetween. That is, due to the downflow from the fan filter unit and the exhaust of the side exhaust duct 36, the chemical liquid tank 32 and the cleaning tank 34 are isolated so as not to be affected by the first actuator 12 and the vertical actuator 14. Therefore, a large separation distance can be secured between the first actuator 12 and the vertical actuator 14 and the opening portion of the chemical liquid tank 32, so that contamination in the chemical module 7 by particles generated from the first actuator 12 and the vertical actuator 14 can be suppressed. Note that the two side exhaust ducts 36, 36 may be eliminated, and the exhaust air may be discharged only from the rear exhaust duct 39.

Next, the second conveyance mechanism 72 will be described with reference to Figs. 1, 2, 4, 8, and 9.

As illustrated in Fig. 1, the second conveyance mechanism 72 is provided above the casing 20 in the loading module 5, the chemical module 7, the drying module 6, and the unloading module 8. As illustrated in Fig. 4, the second conveyance mechanism 72 has, for example, a configuration in which a plurality of second conveyance and accommodation sections 40 and a second actuator 41 are coupled in the second direction. Each of the second conveyance and accommodation sections 40 is configured as a part of each casing 20 of the loading module 5, the chemical module 7, the drying module 6, and the unloading module 8, for example. That is, the second conveyance and accommodation section 40 is formed integrally with the casing 20. Furthermore, the second conveyance and accommodation section 40 can also be configured as a separate box-shaped member. Although Figs. 2 and 4 illustrate an aspect in which the second conveyance and accommodation section 40 is separated from the casing 20 for easy understanding of the configuration of the second conveyance and accommodation section 40, the second conveyance and accommodation section 40 may be an integral member constituting a part of the casing 20 or may be configured as a separate member. The second conveyance and accommodation section 40 and the second actuator 41 are configured to be detachably coupled in the second direction.

As illustrated in Fig. 4, the second conveyance mechanism 72 includes the plurality of second conveyance and accommodation sections 40 and at least one second conveyance section 48. The number of the second conveyance sections 48 provided in the second conveyance mechanism 72 is appropriately increased or decreased according to the number of the second conveyance and accommodation sections 40 to be coupled. The second conveyance section 48 includes the second actuator 41. The second actuator 41 is accommodated in the second conveyance and accommodation section 40. The first actuator 12 and the vertical actuator 14 are accommodated in the chemical module 7, and the second actuator 41 is accommodated in the second conveyance and accommodation section 40. Therefore, since the first actuator 12, the vertical actuator 14, and the second actuator 41 are separately accommodated, contamination in the chemical module 7 can be suppressed.

The second actuator 41 is, for example, an electric linear actuator. The second actuator 41 is, for example, a rack-and-pinion, and includes a flat-plate-shaped guide portion having a gear cut rack, a circular gear called a pinion, a motor that rotates the circular gear, a power supply, and a controller that controls the motor. The flat-plate-shaped guide portion may include a plurality of guide pieces, and the plurality of guide pieces may be detachably coupled in the second direction.

As illustrated in Figs. 8, 9, and 12, the second conveyance section 48 includes, in addition to the second actuator 41, a chuck actuator 42, a coupling arm 43, a chuck portion 44, a holding block 45, a vertical rail 74, and a coupling block 76.

The chuck actuator 42 is a member for integrally driving the coupling arm 43 and the chuck portion 44, and includes a drive source such as a motor, a power supply, and a controller. The chuck actuator 42 is not limited to an electric type, and may be an actuator driven by hydraulic pressure or pneumatic pressure. Two coupling arms 43 are connected to the chuck actuator 42, and the chuck actuator 42 can slide and drive the two coupling arms 43 in a direction approaching each other along the horizontal direction and in a direction away from each other (see arrow X2).

The coupling arm 43 is an arm that connects the chuck actuator 42 and the chuck portion 44. As illustrated in Fig. 9, the coupling arm 43 has a U shape, extends forward from a connection portion of the chuck actuator 42, extends downward, and extends rearward. The coupling arm 43 is accommodated in the second conveyance and accommodation section 40 together with the chuck actuator 42, extends forward through the opening portion 80 provided in the second conveyance and accommodation section 40, extends downward through an opening portion 79 provided in a top surface portion 77 of the casing 20, and extends into the processing space of the casing 20. In the casing 20, a chuck portion 44 is provided in the coupling arm 43.

The chuck portion 44 is a rod-shaped member extending downward from the coupling arm 43, and has a claw-like shape with a tip curved inward. As illustrated in Fig. 4, a case where the chuck portion 44 is attached to each of the coupling arms 43, and two chuck portions 44 are attached to one coupling arm 43 is illustrated in Fig. 4. However, as long as at least one chuck portion 44 (that is, a pair of chuck portions 44) is provided in one coupling arm 43, the number of chuck portions 44 may be any number. The chuck portion 44 is slidably driven in the horizontal direction by the chuck actuator 42 together with the coupling arm 43 (see arrow X2). As illustrated in Fig. 9, the chuck portion 44 is configured to be located immediately above the cleaning tank 34.

The pair of chuck portions 44, 44 separated from each other in the X-axis direction slide in directions approaching each other to sandwich the flange portion 3 of the carrier 2 from both sides, thereby gripping the flange portion 3 of the carrier 2. The gripping of the flange portion 3 of the carrier 2 is released by the sliding movement of the two chuck portions 44, 44 in the direction of separating from each other. Therefore, the pair of chuck portions 44 and 44 can be engaged with and disengaged from the flange portion 3 of the carrier 2.

The holding block 45 is a block that holds the chuck actuator 42. When the holding block 45 holds the chuck actuator 42, the pair of coupling arms 43 connected to the chuck actuator 42 and the chuck portion 44 are integrally held in a slidable state. The holding block 45 is attached to the vertical rail 74.

The vertical rail 74 is a rail-shaped member extending vertically, and is attached to the holding block 45 so as to be vertically movable (see arrow Z1). When the holding block 45 moves vertically along the vertical rail 74, the coupling arm 43 and the chuck portion 44 can integrally move vertically. The vertical rail 74 is coupled to a rail of the second actuator 41 via the coupling block 76.

The coupling block 76 and the vertical rail 74 are driven by the second actuator 41 so as to horizontally move along the X-axis direction which is the second direction (see arrow X1). In Fig. 12, a dotted line and a solid line indicate that the coupling block 76 and the vertical rail 74 move horizontally and the second conveyance section 48 is located at different positions.

In Fig. 12, a solid line and a dotted line indicate that the holding block 45 and the like coupled to the vertical rail 74 move vertically and the second conveyance section 48 is at different height positions. Furthermore, the vertical rail 74 is provided with a vertical actuator 78 for driving the holding block 45 in the vertical direction. The vertical actuator 78 may be incorporated in, for example, the vertical rail 74, and although schematically illustrated in Fig. 12, any configuration may be used.

According to the above configuration, the holding block 45, the coupling arm 43, and the chuck portion 44 of the second conveyance section 48 can be integrally moved in the horizontal direction (arrow X1) and the vertical direction (arrow Z1) by driving the second actuator 41 and the vertical actuator 78. In this configuration, the coupling arm 43 and the chuck portion 44 are slidable in the horizontal direction (arrow X2) by driving of the chuck actuator 42, and can grip the carrier 2 holding the substrate 4 in a freely detachable manner. The chuck portion 44 is not limited to the case of being linearly slide-driven, and may move in an arbitrary direction as long as it can grip the carrier 2 and the substrate 4 in a freely detachable manner, such as being rotationally driven. The second conveyance section 48 according to the present embodiment does not have a function of moving along the Y-axis direction which is the first direction.

As illustrated in Figs. 8 and 9, the internal space of the chemical module 7 is classified into a plurality of regions LV1 to LV3. The chemical module 7 according to the present embodiment includes three regions LV1, LV2, and LV3, and the regions LV1, LV2, and LV3 are disposed in this order from the bottom in the vertical direction. In a case where the region is divided in the vertical direction, the region may be referred to as a "hierarchy". The region is not limited to being divided in the vertical direction, and may be divided in a direction different from the vertical direction (for example, a horizontal direction or an oblique direction). The regions are not limited to the case of not completely overlapping each other, and may partially overlap each other.

In the present embodiment, the first region LV1 is the lowest region among the three regions LV1, LV2, and LV3, and corresponds to the height positions of the cleaning tank 34 and the chemical liquid tank 32. The second region LV2 is a region located between the first region LV1 and the third region LV3, and is used by the first conveyance mechanism 70 to convey the carrier 2 and the substrate 4 in the first direction. The third region LV3 is the highest region among the three regions LV1, LV2, and LV3, and is used for the second conveyance section 48 to move in the second direction together with the substrate 4.

As illustrated in Fig. 8, the first conveyance mechanism 70 has a function of vertically moving the substrate 4 between the first region LV1 and the second region LV2, and the second conveyance mechanism 72 has a function of vertically moving the substrate 4 between the second region LV2 and the third region LV3. Since both the first conveyance mechanism 70 and the second conveyance mechanism 72 can convey the substrate 4 to the second region LV2, the substrate 4 can be transferred in the second region LV2. In the present embodiment, the first conveyance mechanism 70 does not have a function of being raised to the third region LV3, and the second conveyance mechanism 72 also does not have a function of being lowered to the first region LV1.

The first conveyance mechanism 70 and the substrate 4 gripped by the first conveyance mechanism 70 move in the first direction in the second region LV2. That is, the movement range of the substrate 4 in the first direction by the first conveyance mechanism 70 is included in the second region LV2. On the other hand, the second conveyance mechanism 72 and the substrate 4 gripped by the second conveyance mechanism 72 are movable in the second direction in the third region LV3 higher than the second region LV2. That is, the movement range of the substrate 4 in the second direction by the second conveyance mechanism 72 is included in the third region LV3 different from the second region LV2. According to such a configuration, since the first conveyance mechanism 70 and the second conveyance mechanism 72 can move without interfering with each other, there is no restriction when moving each of them independently, and the throughput can be improved.

Note that the second conveyance mechanism 72 is not limited to the case of moving in the second direction in the third region LV3, and may move in the second direction in the second region LV2 in a situation where interference with the first conveyance mechanism 70 does not occur. The controller 101 has a first function of conveying the substrate 4 in the second direction in the second region LV2 and a second function of conveying the substrate 4 in the second direction in the third region LV3, and can further improve the throughput by selectively executing the first function and the second function.

As illustrated in Fig. 9, the opening 37a provided in the side wall 37 is located from second region LV2 to third region LV3. That is, the opening 37a is provided corresponding to the movement range of the second conveyance mechanism 72 and the substrate 4 gripped by the second conveyance mechanism 72. By providing the side wall 37 in a region excluding the opening 37a, occurrence of contamination between adjacent chemical modules 7 can be suppressed.

In particular, the second actuator 41, the chuck actuator 42, and the vertical actuator 78, which are drive mechanisms for driving the chuck portion 44, are all accommodated in the second conveyance and accommodation section 40 above the top surface portion 77 of the casing 20. As described above, by disposing all the drive mechanisms separately from the processing space of the casing 20, contamination can be suppressed, and the inside of the casing 20 can be maintained in a clean state.

Although the specific first embodiment and numerical values of the present invention have been described, the present invention is not limited to the above embodiment, and various modifications can be made within the scope of the present invention.

For example, in the first embodiment described above, the first actuator 12 and the vertical actuator 14 are disposed in the side lower portion (lower portion in the second direction), but may be disposed on the first direction side as necessary.

The number and combination of modules in the substrate processing device 1 can be appropriately designed as necessary, and for example, the chemical module 7 and the drying module 6 can be alternately disposed.

The first embodiment is summarized as follows.

The substrate processing device 1 according to an aspect of the present invention includes the chemical module 7 including the chemical liquid tank 32 that treats the substrate 4 held by the carrier 2 with a chemical liquid and the cleaning tank 34 that cleans the substrate 4 held by the carrier 2,
in which the chemical module 7 includes:
the first conveyance section 11 that conveys the carrier 2 in the first direction in which the chemical liquid tank 32 and the cleaning tank 34 are arranged;
the vertical conveyance section 13 that conveys the carrier 2 in the vertical direction intersecting the first direction; and
the second conveyance section 48 that conveys the carrier 2 in the second direction intersecting the first direction and the vertical direction,
in which the first conveyance section 11, the second conveyance section 48, and the vertical conveyance section 13 are driven by the first actuator 12, the second actuator 41, and the vertical actuator 14, respectively, and
the first actuator 12, the second actuator 41 and the vertical actuator 14 are isolated from the chemical liquid tank 32 and the cleaning tank 34.

According to the above configuration, by the conveyance in the first direction by the first conveyance section 11 and the conveyance in the second direction by the second conveyance section 48, the other chemical liquid tank 32 and the cleaning tank 34 located adjacent to each other are isolated so as not to be affected by the chemical liquid attached to the carrier 2 to be conveyed, so that contamination by the chemical liquid can be suppressed. Furthermore, since the actuators 12, 41, and 14 for driving the conveyance sections 11, 48, and 13 that convey the carrier 2 are isolated so as not to be affected by the chemical liquid tank 32 and the cleaning tank 34, contamination by particles of the carrier 2 in the chemical module 7 can be suppressed. Furthermore, since the chemical liquid tank 32 and the cleaning tank 34 are arranged in the first direction, the width of the chemical module 7 in the second direction is narrowed, so that the substrate processing device 1 can be downsized. Furthermore, since the device for processing each process is modularized, it is possible to flexibly respond to the change needs by connecting the other modules 5, 6, and 8 to the chemical module 7.

In the substrate processing device 1 according to one embodiment, the chemical module 7 is configured to be detachably coupled in the second direction.

According to the above embodiment, it is possible to flexibly respond to the need for changing the processing process, and the expandability is enhanced.

Furthermore, in the substrate processing device 1 according to the embodiment, the first actuator 12 and the vertical actuator 14 are provided below the respective opening portions of the chemical liquid tank 32 and the cleaning tank 34.

According to the above embodiment, it is possible to suppress contamination in the chemical module 7 by particles generated from the first actuator 12 and the vertical actuator 14.

Furthermore, the substrate processing device 1 according to the embodiment further includes the loading module 5 that carries in the carrier 2 holding the substrate 4, the drying module 6 that dries the substrate 4 held by the carrier 2, or the unloading module 8 that carries out the carrier 2 holding the substrate 4,
in which the loading module 5, the drying module 6, and the unloading module 8 are configured to be detachably coupled in the second direction.

According to the above embodiment, it is possible to flexibly respond to the need for changing the processing process, and the expandability is enhanced.

Furthermore, in the substrate processing device 1 according to the embodiment, a side of the chemical liquid tank 32 in the second direction is partitioned by the side wall 37.

According to the above embodiment, it is possible to suppress contamination due to the atmosphere of the chemical liquid stored in the chemical liquid tanks 32 of the adjacent chemical modules 7.

Furthermore, in the substrate processing device 1 according to the embodiment, the chemical liquid tank 32 is provided on the rear side in the first direction, and the cleaning tank 34 is provided on the front side in the first direction.

According to the above embodiment, since the exhaust duct 39 for exhausting the chemical liquid vapor generated from the chemical liquid tank 32 can be provided on the rear side in the first direction, maintenance of the substrate processing device 1 becomes easy.

Note that, in the first embodiment described above, the case where the plurality of substrates 4 is held by the carrier 2 has been described, but the present invention is not limited to such a case, and a carrier-less configuration may be employed. For example, the plurality of substrates 4 may be directly held by the chuck portion 44 or the pedestal 18.

Next, a relationship between a drive space in which the actuators 12, 14, 41, 42, and 78 are disposed and a treatment space in which the substrate 4 is treated will be described with reference to Figs. 8 and 9.

As illustrated in Figs. 8 and 9, the casing 20 forms a treatment space A for processing the substrate 4. The treatment space A is a space in which the chemical liquid tank 32 and the cleaning tank 34 are disposed inside, and the plurality of substrates 4 is conveyed in the front-rear direction (first direction) and the lateral direction (second direction). The treatment space A is surrounded by a pair of side walls 37 and a rear wall 38.

As illustrated in Figs. 8 and 9, the casing 20 forms a first drive space B1. The first drive space B1 is a space for disposing the first actuator 12 and the vertical actuator 14. The first drive space B1 is formed laterally and downwardly in the second direction with respect to the respective opening portions of the chemical liquid tank 32 and the cleaning tank 34.

As illustrated in Figs. 8 and 9, the casing 20 forms a second drive space B2. The second drive space B2 is a space for disposing a drive mechanism for driving the chuck portion 44, such as the second actuator 41, the chuck actuator 42, and the vertical actuator 78. The second drive space B2 is formed above the treatment space A.

By disposing the actuators 12, 14, 41, and 78 in the drive spaces B1 and B2, the actuators 12, 14, 41, and 78 can be isolated from the treatment space A. Therefore, entry of foreign matter generated from the actuators 12, 14, 41, and 78 into the treatment space A can be suppressed, and contamination in the chemical module 7 can be suppressed.

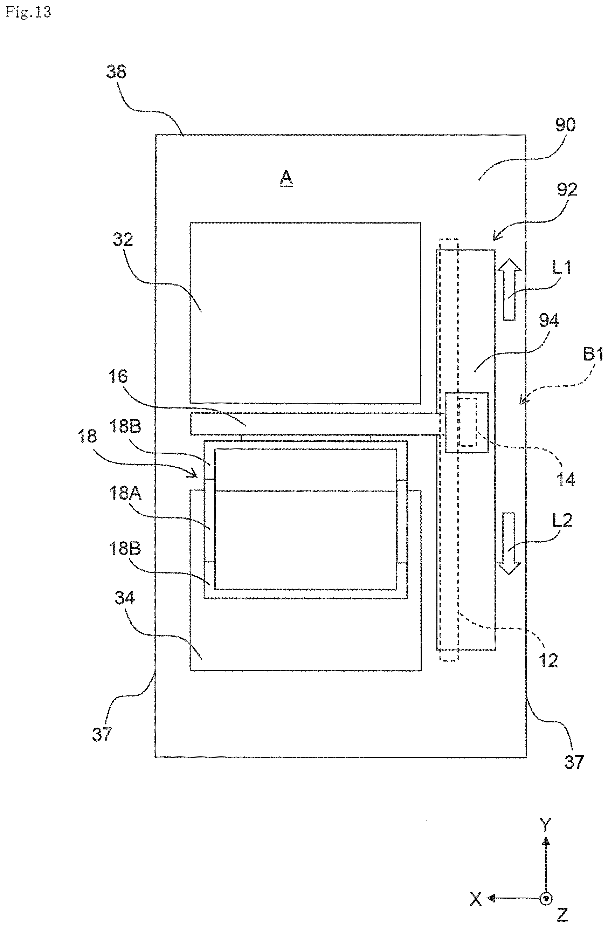

As illustrated in Fig. 3, the first drive space B1 and the treatment space A are isolated by a side exhaust duct 36. Not limited to such a case, for example, the first drive space B1 and the treatment space A may be isolated by providing a wall portion that partitions the first drive space B1 and the treatment space A. An example thereof will be described with reference to Fig. 13.

Fig. 13 is a schematic plan view illustrating a treatment space A according to a modification. As illustrated in Fig. 13, a bottom wall 90 is provided so as to surround the chemical liquid tank 32 and the cleaning tank 34. The bottom wall 90 is a wall portion constituting a bottom portion of the treatment space A. An opening 92 is formed in a part of the bottom wall 90, and a movable wall 94 is provided below the opening 92. The movable wall 94 is disposed so as to cover the opening 92, and moves integrally with the arm 16 supporting the pedestal 18 in the front-rear direction (arrows L1 and L2). The movable wall 94 has a long shape in the front-rear direction, and has a length that covers the entire opening 92 at all times in a range where the arm 16 moves. The arm 16 extends downward so as to penetrate the movable wall 94 and is connected to the vertical actuator 14. The arm 16 is disposed in close contact with a through hole of the movable wall 94 through which the arm 16 passes. In the example illustrated in Fig. 13, the side exhaust duct 36 is not provided.

According to the configuration illustrated in Fig. 13, by providing the movable wall 94 through which the arm 16 is inserted, it is possible to physically separate the treatment space A and the first drive space B1 while enabling the arm 16 to move in the front-rear direction. Therefore, contamination in the chemical module 7 can be more reliably suppressed.

Furthermore, in the example illustrated in Fig. 13, the pedestal 18 includes an upper step portion 18A and a lower step portion 18B in an outer frame portion constituting a space for accommodating the carrier 2. The upper step portion 18A is a portion protruding upward from the lower step portion 18B, and has a function of supporting the flange portion 3 of the carrier 2 from below. The lower step portion 18B is a portion located below the upper step portion 18A, and forms a gap for disposing the tip of the chuck portion 44 (claw shape) of the second conveyance section 48. By providing the lower step portion 18B, even in a state where the flange portion 3 of the carrier 2 is supported by the upper step portion 18A, the chuck portion 44 of the second conveyance section 48 can support the flange portion 3 of the carrier 2 at a position different from the upper step portion 18A. Therefore, the chuck portion 44 and the pedestal 18 can hold the carrier 2 without interfering with each other, and the carrier 2 can be easily transferred between the chuck portion 44 and the pedestal 18.

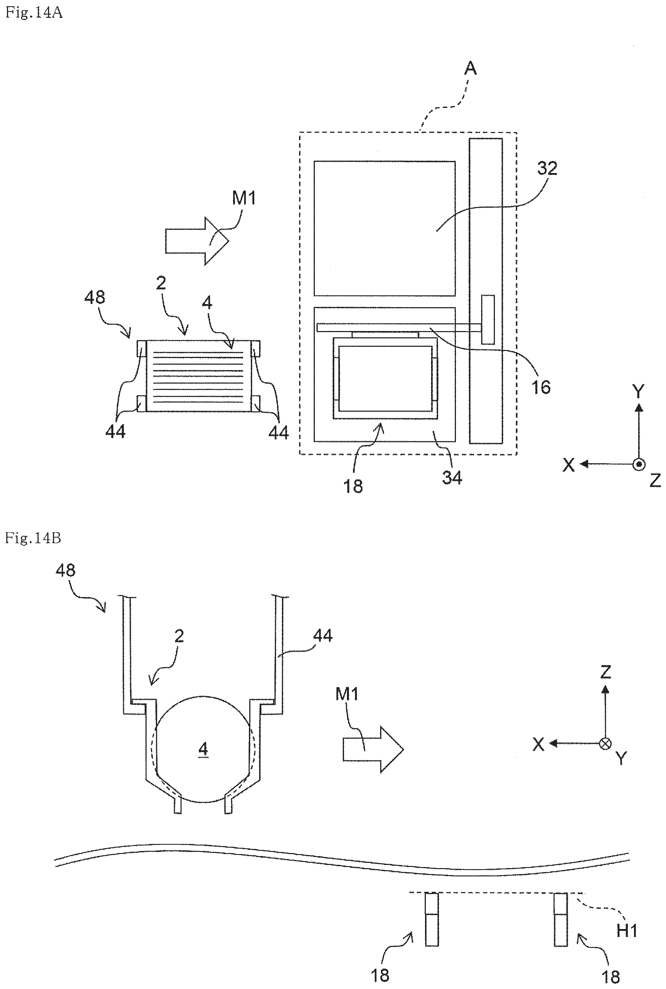

Next, an example of the operation of the substrate processing device 1 will be described with reference to Figs. 14A to 26B.

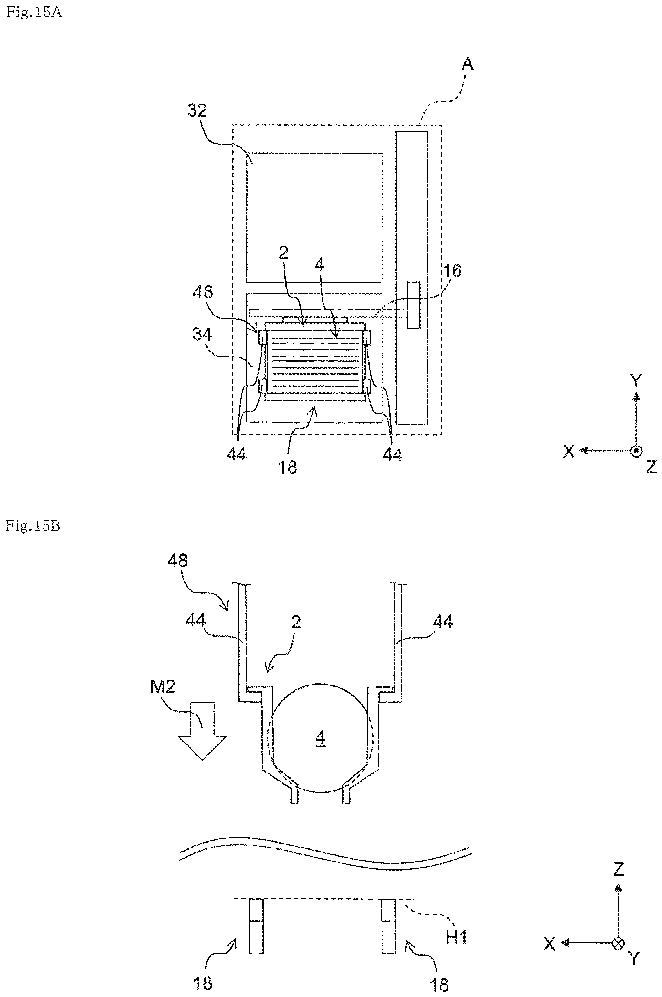

Figs. 14A to 26B are schematic diagrams for illustrating an example of the operation of the substrate processing device 1. Figs. 14A, 15A, ..., and 26A are each a plan view of a treatment space A, and Figs. 14B, 15B, ..., and 26B are each a side view illustrating a peripheral configuration of the pedestal 18 and the substrate 4. Figs. 14A and 14B correspond to the same state, Figs. 15A and 15B correspond to the same state, ..., and the other drawings correspond to the same.

As illustrated in Figs. 14A and 14B, first, in the treatment space A, the pedestal 18 of the first conveyance mechanism 70 stands by above the cleaning tank 34. As illustrated in Fig. 14B, the pedestal 18 is disposed at a raised position H1 included in the second region LV2 described above. In a state where the pedestal 18 stands by, as illustrated in Fig. 14A, the second conveyance section 48 of the second conveyance mechanism 72 moves the carrier 2 holding the plurality of substrates 4 in the lateral direction (second direction) (arrow M1). The chuck portion 44 of the second conveyance section 48 and the carrier 2 and the substrate 4 gripped by the chuck portion 44 move in the lateral direction in the third region LV3 described above, for example, and thus do not interfere with the pedestal 18 disposed in the second region LV2. In a situation where interference with the pedestal 18 illustrated in Fig. 14A or the pedestal 18 or the substrate 4 in another module does not occur, the second conveyance mechanism 72 may move the carrier 2 and the substrate 4 in the second region LV2 in the lateral direction.

As illustrated in Figs. 15A and 15B, the second conveyance section 48 moves the carrier 2 holding the substrate 4 to above the pedestal 18. Thereafter, the holding block 45 described above is lowered along the vertical rail 74 to cause the second conveyance section 48 to be integrally lowered toward the second region LV2 (arrow M2) and cause the pedestal 18 to hold the carrier 2.

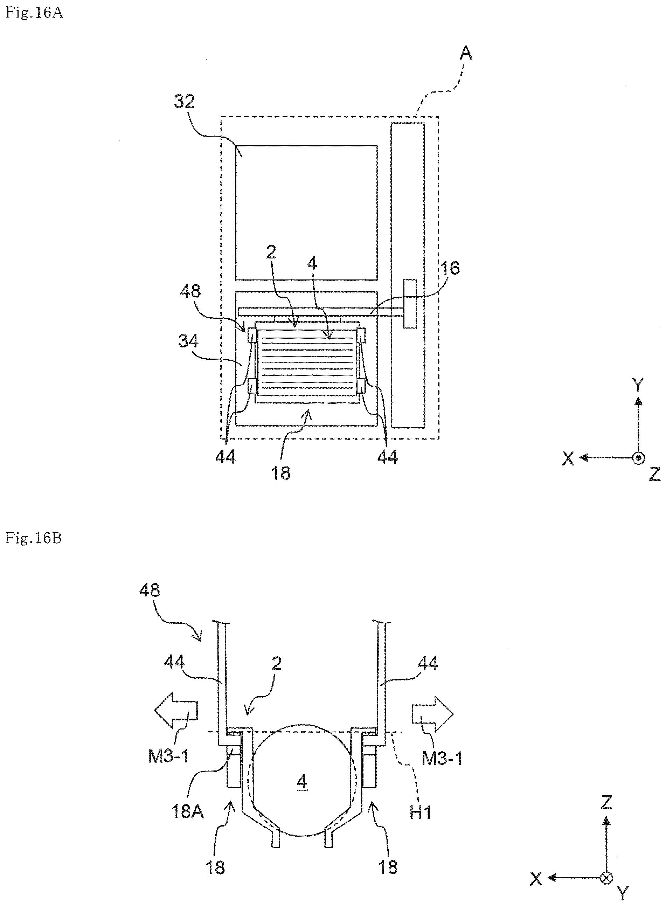

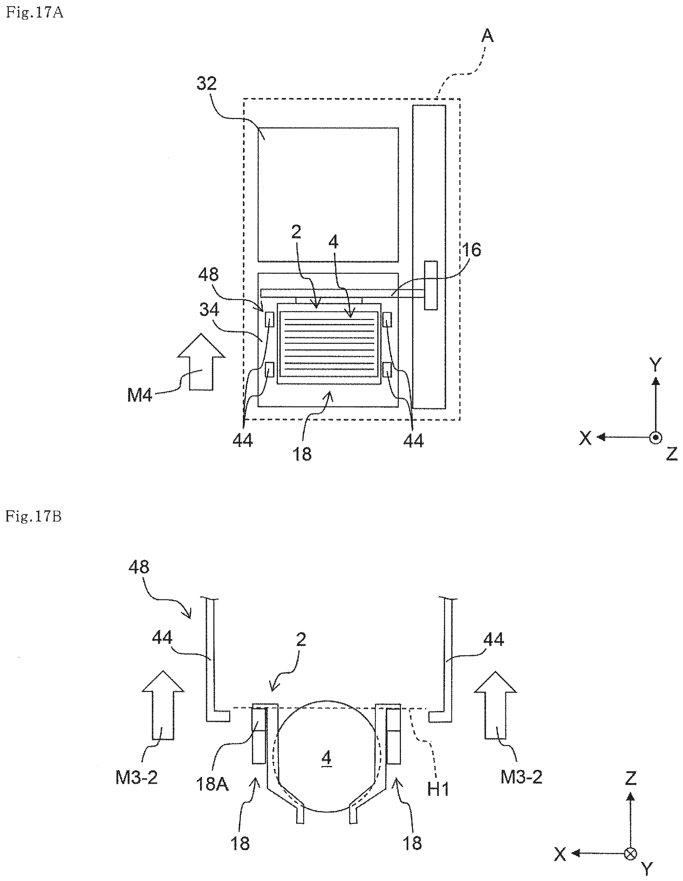

As illustrated in Figs. 16A and 16B, the upper step portion 18A of the pedestal 18 is brought into contact with the flange portion 3 of the carrier 2 and supports the flange portion from below. As described with reference to Fig. 13, the chuck portion 44 supports the flange portion 3 of the carrier 2 at a position different from the upper step portion 18A of the pedestal 18, and does not interfere with the pedestal 18. Thereafter, the chuck portion 44 is moved in the opening direction (arrow M3-1) to release the gripping of the substrate 4. Therefore, as illustrated in Figs. 17A and 17B, the carrier 2 is transferred from the chuck portion 44 to the pedestal 18.

As illustrated in Fig. 17B, the chuck portion 44 from which the gripping of the carrier 2 has been released is raised and retracts (arrow M3-2). The chuck portion 44 retracted to the third region LV3 can freely move in the lateral direction (second direction) without interfering with the carrier 2, the substrate 4, the pedestal 18, the arm 16, and the like disposed in the second region LV2. The pedestal 18 moves to the rear side in the first direction toward the chemical liquid tank 32 as illustrated in Fig. 17A while holding the carrier 2 at the raised position H1 (arrow M4). In a state where the chuck portion 44 is opened outward, the pedestal 18 and the carrier 2 can move in the first direction without interfering with the chuck portion 44, and thus, may move in the first direction without waiting for the chuck portion 44 to be raised.

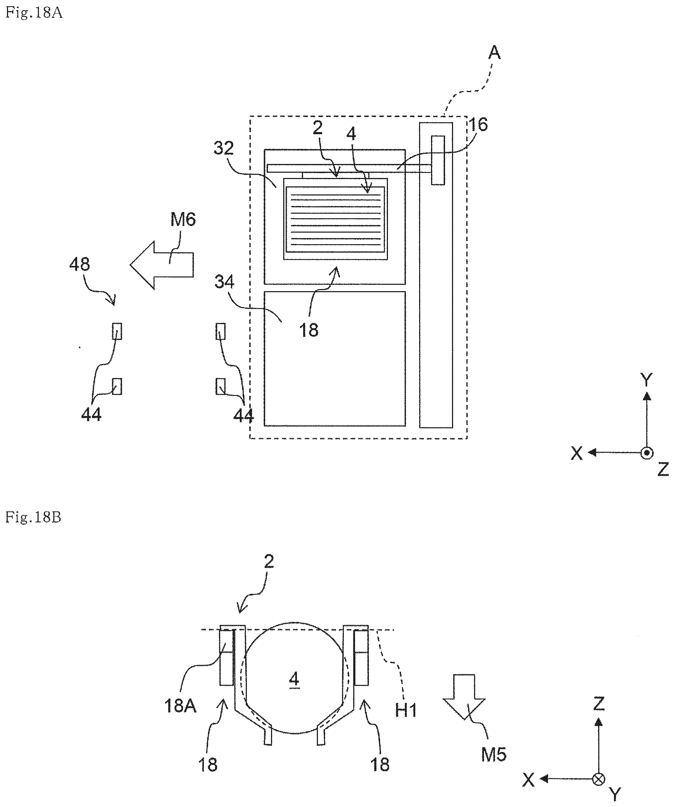

As illustrated in Fig. 18A, the carrier 2 and the pedestal 18 move to above the chemical liquid tank 32 and stop. In this state, as illustrated in Fig. 18B, the carrier 2 and the pedestal 18 are lowered (arrow M5), and the substrate 4 is immersed in the chemical liquid stored in the chemical liquid tank 32. Since the chuck portion 44 retracted to the third region LV3 is freely movable in the second direction as illustrated in Fig. 18A (arrow M6), the chuck portion can be moved to another module to hold the carrier 2 to be processed next, or can be retracted from immediately above the cleaning tank 34. In the example illustrated in Fig. 18A, the second conveyance section 48 is retracted in the second direction from immediately above the cleaning tank 34, but does not interfere with the members disposed in the first region LV1 and the second region LV2. Therefore, the second conveyance section 48 may be kept on standby above the cleaning tank 34 without being retracted. Furthermore, the chuck portion 44 is not limited to the case of retreating to the third region LV3, and may move in the second direction while remaining in the second region LV2 without being raised to the third region LV3 in a situation where the chuck portion does not interfere with the pedestal 18 or the substrate 4 in other modules.

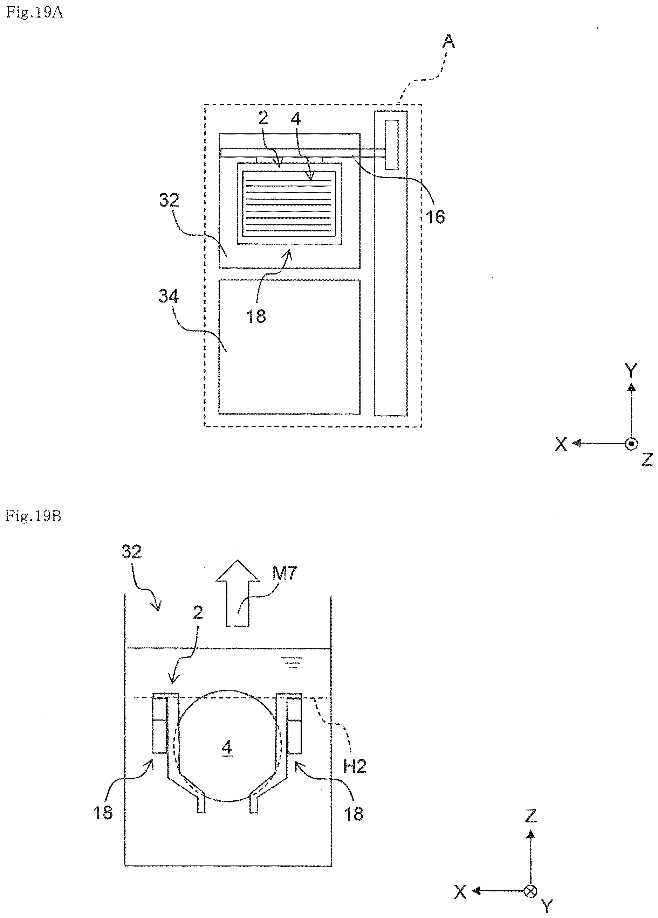

As illustrated in Figs. 19A and 19B, the pedestal 18 is lowered to a lowered position H2 which is a height position at which the plurality of substrates 4 is immersed in the chemical liquid. By immersing the substrate 4 in a chemical liquid, a treatment such as etching can be performed on the surface of the substrate 4.

As the chemical liquid in the chemical liquid tank 32, any liquid may be used as long as it can treat the surface of the substrate 4. For example, in the case of an organic chemical liquid, an amine solution such as NMP or monoethanolamine, acetone, or the like may be used, and in the case of an inorganic chemical liquid, SC1 (APM), SC2 (HPM), SPM, hydrofluoric acid (HF), buffered hydrofluoric acid (BHF), or the like may be used. Furthermore, one kind of liquid may be used alone, or two or more kinds of liquids may be used in combination.

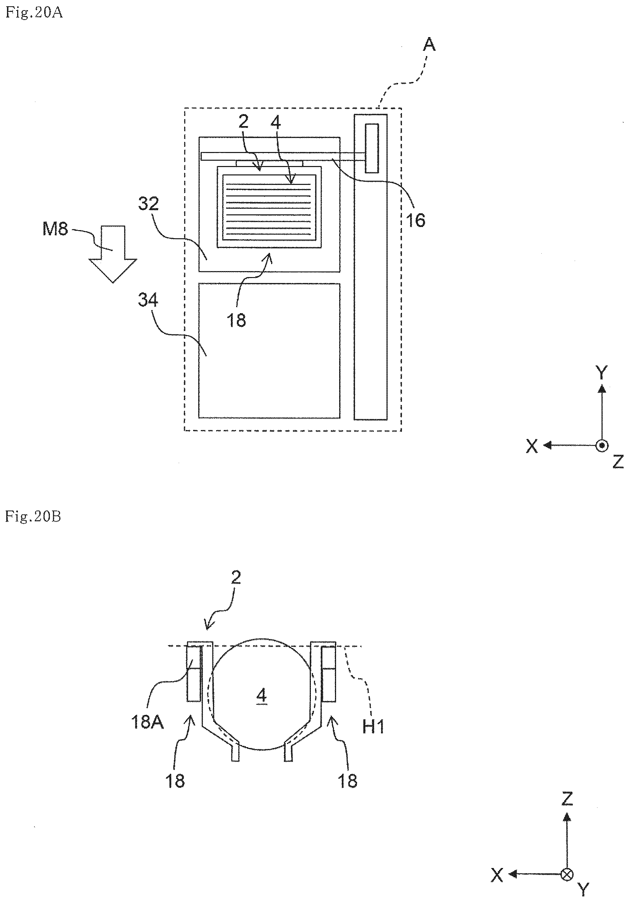

When the chemical liquid treatment of the substrate 4 is completed, the carrier 2 and the pedestal 18 are raised (arrow M7), and the substrate 4 is pulled up. As illustrated in Fig. 20B, the pedestal 18 is raised to the raised position H1 included in the second region LV2. In this state, as illustrated in Fig. 20A, the carrier 2 and the pedestal 18 are moved forward in the first direction toward the cleaning tank 34 (arrow M8).

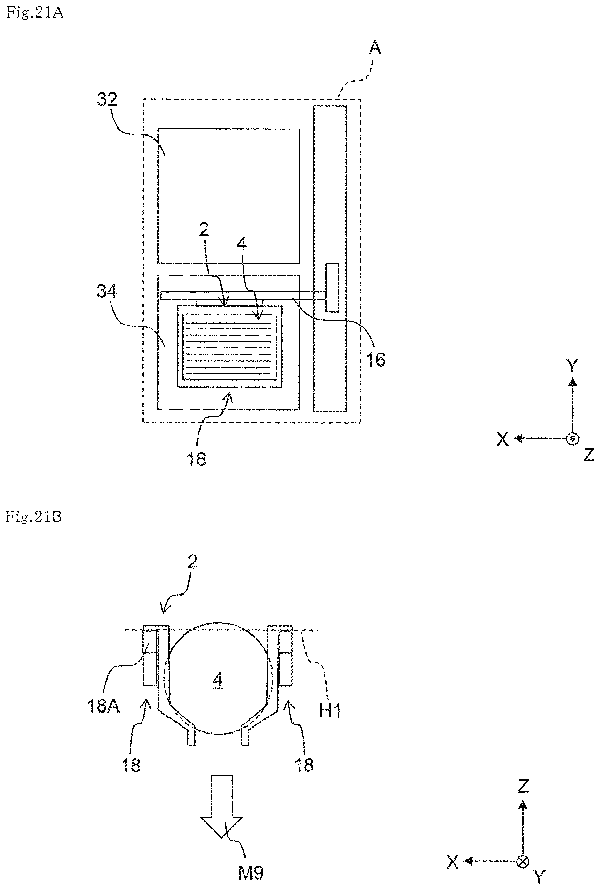

As illustrated in Fig. 21A, the carrier 2 and the pedestal 18 move to immediately above the cleaning tank 34 and stop. Thereafter, as illustrated in Fig. 21B, the carrier 2 and the pedestal 18 are lowered (arrow M9), and the substrate 4 is disposed inside the cleaning tank 34.

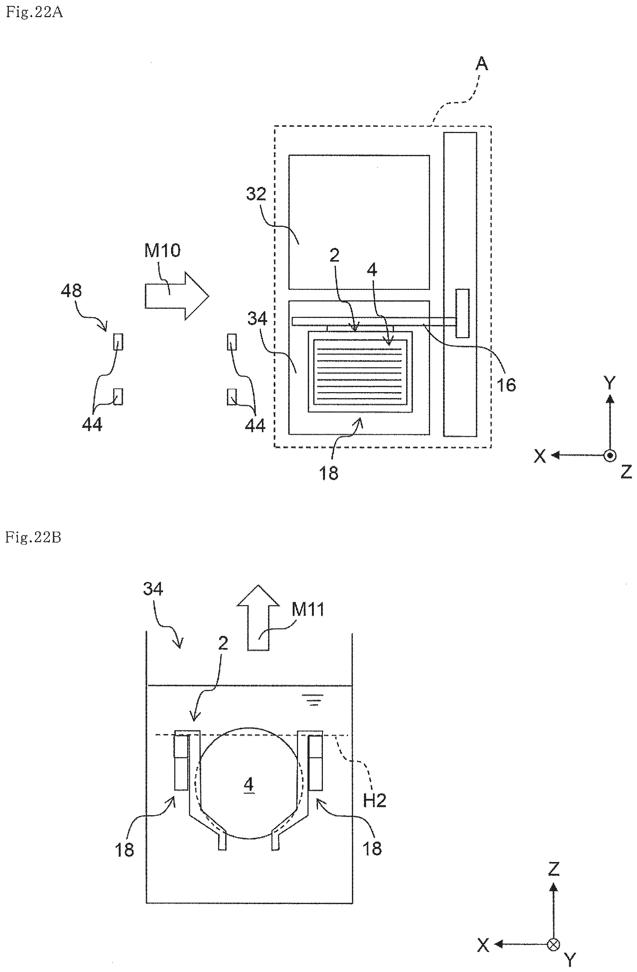

As illustrated in Fig. 22B, in a state where the pedestal 18 is lowered to the lowered position H2, the substrate 4 is immersed in cleaning water such as pure water stored in the cleaning tank 34. Therefore, the surface of the substrate 4 to which the chemical liquid adheres can be subject to a rinse treatment. Not limited to the case of being immersed in cleaning water, cleaning water may be jetted to the substrate 4. As the rinse treatment, any liquid and method may be used as long as the chemical liquid adhering to the surface of the substrate 4 can be replaced to a state that does not cause a problem in the next treatment. For example, a protic solvent, water, an alcohol such as IPA or ethanol, or an amine solution such as NMP or monoethanolamine may be used. Furthermore, one kind of liquid may be used alone, or two or more kinds of liquids may be used in combination.

As illustrated in Fig. 22A, in a case where the second conveyance section 48 is retracted, the second conveyance section 48 may be moved in the second direction to return to above the cleaning tank 34 while the substrate 4 is subject to the rinse treatment (arrow M10). In a case where the second conveyance section 48 is disposed in the third region LV3, regardless of whether or not the second conveyance section 48 is immediately above the cleaning tank 34, as illustrated in Fig. 22B, the carrier 2 and the pedestal 18 that hold the substrate 4 for which the rinse treatment has been completed can be raised toward the second region LV2 (arrow M11).

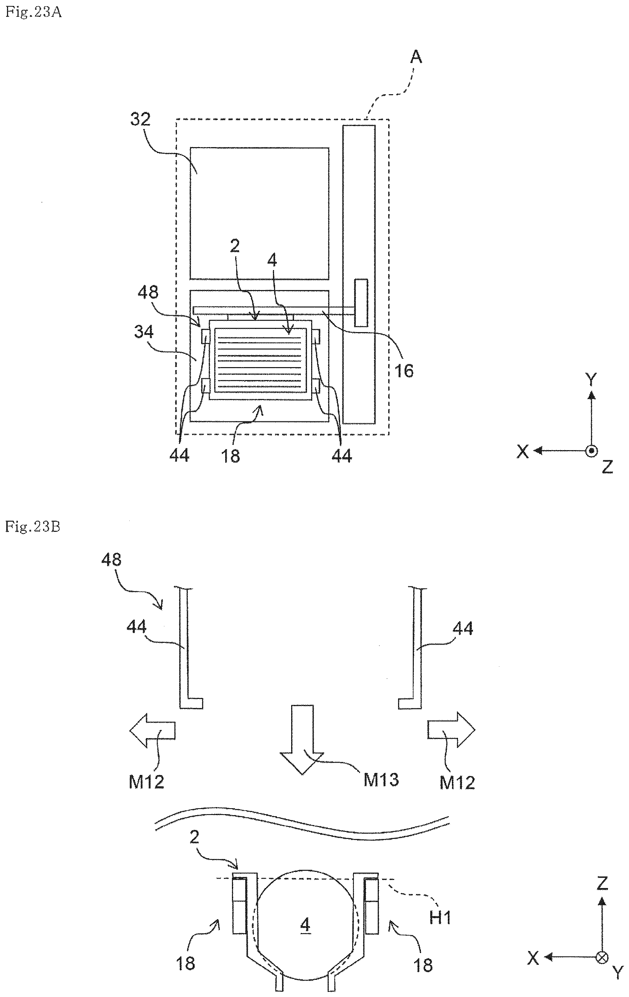

As illustrated in Fig. 23B, the pedestal 18 is raised to the raised position H1, which is a position for transferring the carrier 2 to the chuck portion 44, and is disposed in the second region LV2. The second conveyance section 48 disposed in the third region LV3 moves in a direction of opening the chuck portion 44 (arrow M12) and then is integrally lowered toward the second region LV2 (arrow M13).

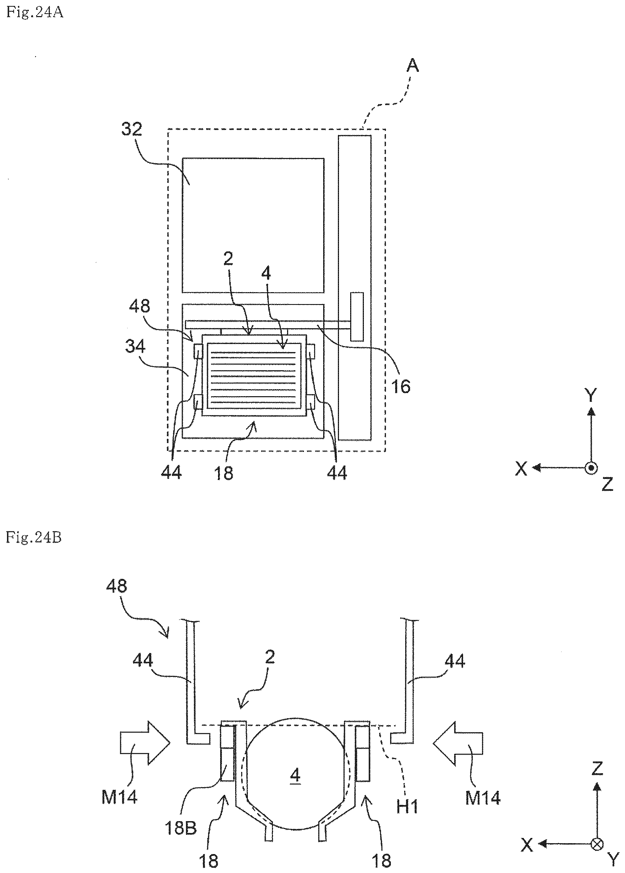

As illustrated in Figs. 24A and 24B, in a state where the chuck portion 44 is lowered and disposed in the second region LV2, the chuck portion 44 is moved in a closing direction (arrow M14), and the plurality of substrates 4 is gripped by the chuck portion 44. The chuck portion 44 is inserted into a gap between the lower step portion 18B of the pedestal 18 and the flange portion 3 of the carrier 2, and supports the flange portion 3 from below.

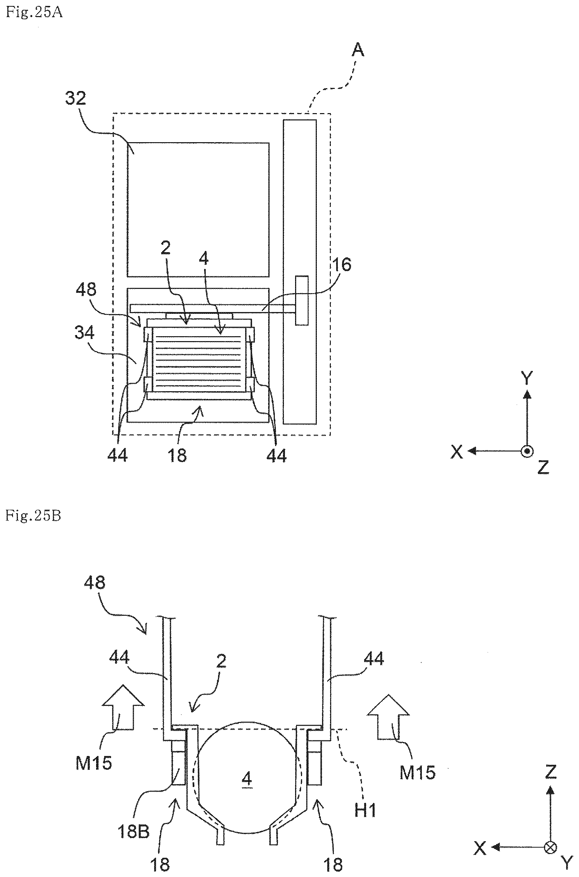

Thereafter, as illustrated in Figs. 25A and 25B, the second conveyance section 48 is raised in a state where the carrier 2 is held by the chuck portion 44 (arrow M15). Therefore, the holding of the carrier 2 by the pedestal 18 is released, and the carrier 2 is transferred from the pedestal 18 to the chuck portion 44.

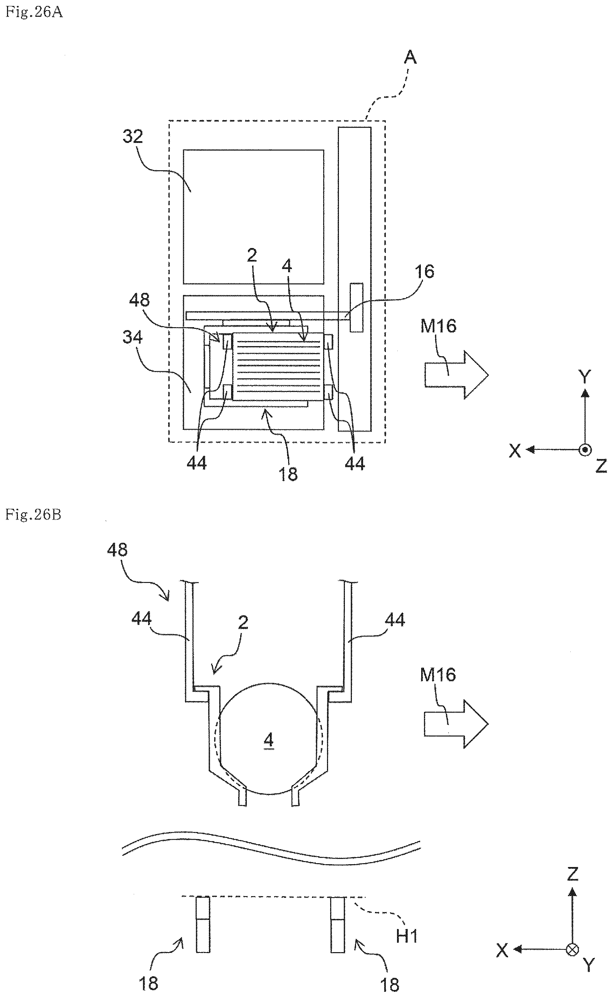

As illustrated in Figs. 26A and 26B, the second conveyance section 48 and the carrier 2 and the substrate 4 gripped by the second conveyance section 48 are raised to the third region LV3, and freely move in the second direction without interfering with the pedestal 18 and the arm 16 disposed in the second region LV2 (arrow M16).

According to the operation illustrated in Figs. 14A to 26B, the substrate 4 is conveyed in the front-rear direction by using the chemical liquid tank 32 and the cleaning tank 34 arranged in the front-rear direction (first direction) in the treatment space A of the chemical module 7 (first conveyance step), the chemical liquid treatment and the rinse treatment are executed on the substrate 4, and when both treatments are completed, the substrate 4 can be conveyed in the lateral direction (second direction) toward the next chemical module 7 (second conveyance step). By executing the first conveyance step and the second conveyance step, the substrate 4 that has been subjected to the treatment such as an etching treatment can be manufactured.

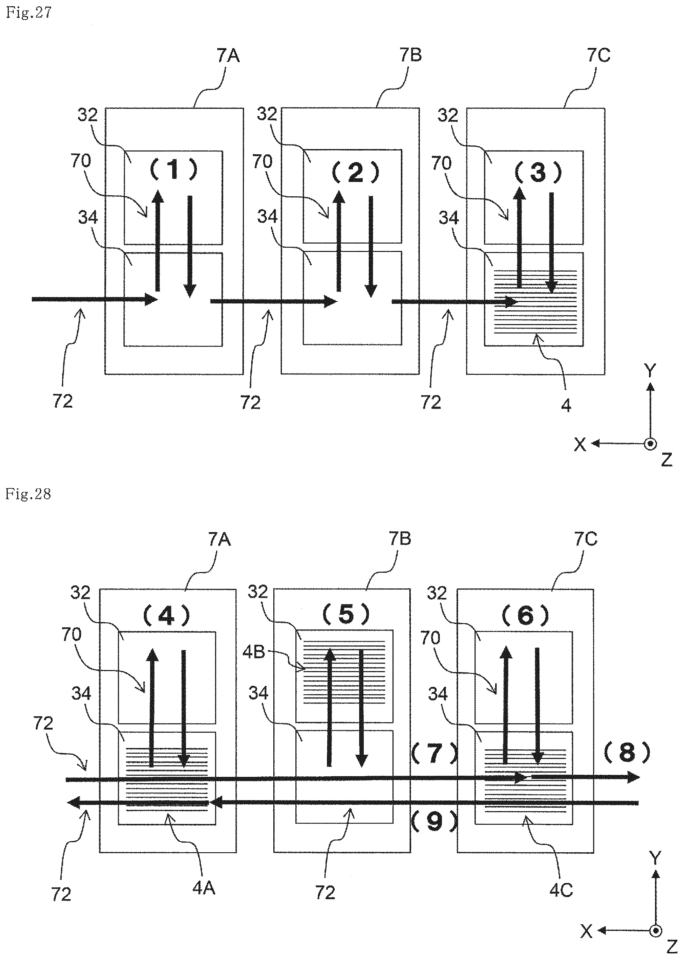

In a case where the substrates 4 are processed in one batch, the operations illustrated in Figs. 14A to 26B may be executed for each module for one batch of the substrates 4. As illustrated in the schematic plan view of Fig. 27, when the substrate 4 is processed by the chemical module 7A (1), the substrate 4 is conveyed to the next chemical module 7B and another processing is executed (2), and the substrate 4 is conveyed to the next chemical module 7C and another processing is executed (3). Note that the order of the operations (1) to (3) is not particularly limited, and may be a random order. That is, it is not necessary to convey the substrate 4 in the order in which the chemical modules 7A, 7B, and 7C are arranged and to execute processing in each module.

In a case where the substrate 4 is processed in a plurality of batches, as illustrated in the schematic plan view of Fig. 28, it is possible to perform processing on the substrate 4A by the chemical module 7A (4), while performing processing on another substrate 4B by another chemical module 7B (5), and further performing processing on another substrate 4C by another chemical module 7C (6). Since the first conveyance mechanism 70 is provided in each of the modules 7A, 7B, and 7C, conveyance and processing of the substrate can be executed in parallel in each of the modules 7A, 7B, and 7C. Note that the order of the operations (4) to (6) is not particularly limited, and may be a random order. For example, the substrate 4C may be conveyed to the chemical module 7C, then the substrate 4A may be conveyed to the chemical module 7A, then the substrate 4B may be conveyed to the chemical module 7B, and the substrates 4A, 4B, and 4C may be processed by the modules 7A, 7B, and 7C, respectively.

In the example illustrated in Fig. 28, the substrates 4A and 4C are disposed inside or immediately above the cleaning tank 34, and the substrate 4B is disposed inside or immediately above the chemical liquid tank 32. All of the substrates 4A, 4B, and 4C and the first conveyance mechanism 70 that conveys the substrates 4A, 4B, and 4C are disposed in the first region LV1 or the second region LV2. When the second conveyance mechanism 72 moves in the lateral direction in the third region LV3 at a position higher than the second region LV2, the second conveyance mechanism 72 can freely move in the second direction regardless of the positions and states of the substrate 4 and the first conveyance mechanism 70 in the modules 7A, 7B, and 7C. As illustrated in Fig. 28, regardless of the states of the chemical modules 7A and 7B, the second conveyance mechanism 72 moves in the second direction through the chemical modules 7A and 7B, and can access the chemical module 7C (7). The second conveyance mechanism 72 that has moved to the chemical module 7C can receive the substrate 4C that has been processed and convey the substrate 4C to the next chemical module 7 (8). After transferring the substrate 4C to the next chemical module 7, the second conveyance mechanism 72 moves to the module (for example, chemical module 7A) in which the processing of the substrate 4A or 4B is completed among the chemical modules 7A and 7B (9), receives the processed substrate 4A, and conveys it to the next chemical module 7. Since the substrate 4A (and the carrier 2) gripped by the second conveyance mechanism 72 is also disposed in the third region LV3, even the second conveyance mechanism 72 in a state of gripping the substrate 4A can freely move in the second direction regardless of the positions and states of another substrate 4 and the first conveyance mechanism 70 in another module.

According to the above operation, the plurality of batches of substrates 4A, 4B, and 4C can be processed in parallel in each module, and the second conveyance mechanism 72 crossing the modules during the processing can be moved in the lateral direction. Therefore, it is possible to realize an operation that cannot be realized by a configuration in which a plurality of tanks is arranged in a row in the lateral direction as in the conventional substrate processing device, and it is possible to greatly improve the processing efficiency.

As described above, the second conveyance mechanism 72 is not limited to the case of moving the third region LV3 in the second direction (second function), and may be the case of moving the second region LV2 in the second direction (first function) in a case where interference with the first conveyance mechanism 70 or the like does not occur. The controller 101 selectively executes the first function and the second function according to various conditions, so that the throughput can be further improved.

### (Operation and Effect)

As described above, the chemical module 7 (substrate processing module) according to the first embodiment includes the cleaning tank 34 (first tank) and the chemical liquid tank 32 (second tank) that are arranged in the first direction and in which the substrate 4 can be disposed, the first conveyance mechanism 70 that moves the substrate 4 in the first direction (Y-axis direction), and the second conveyance mechanism 72 that moves the substrate 4 in the second direction (X-axis direction) intersecting the first direction, the cleaning tank 34 and the chemical liquid tank 32 are disposed in the first region LV1, the first conveyance mechanism 70 conveys the substrate 4 in the first direction in the second region LV2 disposed above the first region LV1, and the second conveyance mechanism 72 conveys the substrate 4 in the second direction in the third region LV3 different from the second region LV2.

According to such a configuration, when the second conveyance mechanism 72 conveys the substrate 4 in the second direction, the substrate 4 can be conveyed without interfering with the first conveyance mechanism 70 and the like, and the throughput can be improved.

Furthermore, in the chemical module 7 according to the first embodiment, the first region LV1, the second region LV2, and the third region LV3 are disposed in this order from the bottom in the vertical direction. According to such a configuration, the regions LV1, LV2, and LV3 can be divided in the vertical direction, and the space in the height direction can be effectively used.

Furthermore, in the chemical module 7 according to the first embodiment, the first conveyance mechanism 70 includes the vertical actuator 14 (first vertical actuator) that vertically moves the substrate 4 between the first region LV1 and the second region LV2, and the second conveyance mechanism 72 includes the vertical actuator 78 (second vertical actuator) that vertically moves the substrate 4 between the second region LV2 and the third region LV3. According to such a configuration, both the first conveyance mechanism 70 and the second conveyance mechanism 72 can access the second region LV2 and transfer the substrate 4 in the second region LV2.

Furthermore, the chemical module 7 according to the first embodiment further includes the controller 101, and the controller 101 controls the first conveyance mechanism 70 and the second conveyance mechanism 72 so as to transfer the substrate 4 in the second region LV2. According to such a configuration, by transferring the substrate 4 in the second region LV2, the first conveyance mechanism 70 does not need to raise the substrate 4 to the third region LV3, and the vertical length of the vertical actuator 14 of the first conveyance mechanism 70 can be shortened, and contamination can be suppressed.

Furthermore, in the chemical module 7 according to the first embodiment, the controller 101 controls the second conveyance mechanism 72 so as to selectively execute the first function of conveying the substrate 4 in the second direction (Y direction) in the second region LV2 and the second function of conveying the substrate 4 in the second direction in the third region LV3. According to such a configuration, the throughput can be improved by selectively executing the first function and the second function according to the situation.

Furthermore, in the chemical module 7 according to the first embodiment, the cleaning tank 34 is disposed on the front side in the first direction, the chemical liquid tank 32 is disposed on the rear side in the first direction, and the second conveyance mechanism 72 moves the substrate 4 above the cleaning tank 34. According to such a configuration, it is possible to reduce contamination between the chemical liquid tanks 32 between the modules. Furthermore, when the operator confirms the inside of the chemical module 7 from the front, the substrate 4 conveyed by the second conveyance mechanism 72 is easily visually recognized.

Furthermore, in the chemical module 7 according to the first embodiment, another module coupled to the chemical module 7 in the second direction is any one of the loading module 5, the unloading module 8, the drying module 6, and the chemical module 7. According to such a configuration, modules having various functions can be coupled as another module.

Furthermore, the substrate processing device 1 according to the first embodiment includes the chemical module 7 and another module (loading module 5, drying module 6, chemical module 7, or unloading module 8) coupled to the chemical module 7 in the second direction. According to such a configuration, it is possible to realize the substrate processing device 1 having a small installation area and high processing efficiency.

### (Second Embodiment)

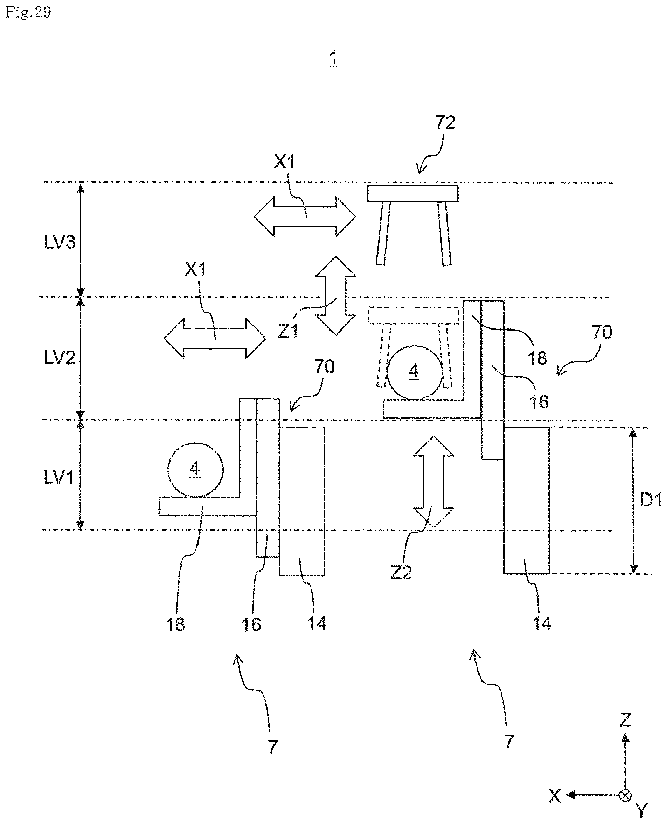

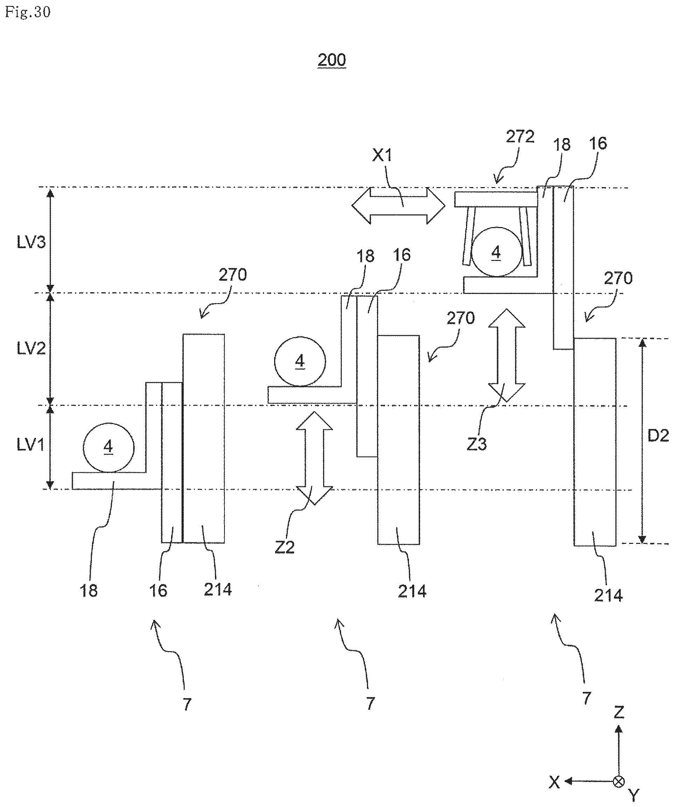

A difference between the substrate processing device 1 according to the first embodiment and a substrate processing device 200 according to a second embodiment will be described with reference to Figs. 29 and 30. Here, the same or similar configurations as those in the first embodiment will be described with the same names and reference signs. Furthermore, description overlapping the first embodiment will be omitted.

Fig. 29 is a schematic diagram illustrating a state in which the substrate 4 is disposed on each of the plurality of chemical modules 7 in the substrate processing device 1 according to the first embodiment, and Fig. 30 is a schematic diagram illustrating a state in which a substrate 4 is disposed on each of a plurality of chemical modules 7 in the substrate processing device 200 according to the second embodiment.

In the first embodiment, both the first conveyance mechanism 70 and the second conveyance mechanism 72 have the vertical movement function and transfer the substrate 4 in the second region LV2 that is an intermediate layer, whereas in the second embodiment, only a first conveyance mechanism 270 has a vertical movement function, a second conveyance mechanism 272 does not have the vertical movement function, and a substrate 4 is transferred in a third region LV3 that is an uppermost layer.

In Figs. 29 and 30, a "carrier-less" case in which the conveyance mechanisms 70, 72, 270, and 272 directly hold the substrate 4 is exemplified.

In the example illustrated in Fig. 29, in the chemical module 7 on the left side, the substrate 4 supported by the pedestal 18 is disposed in the first region LV1, and is treated in the cleaning tank 34 (not illustrated). In the chemical module 7 on the right side, the vertical actuator 14 of the first conveyance mechanism 70 raises the substrate 4 and disposes the substrate 4 in the second region LV2. The first conveyance mechanism 70 can convey the substrate 4 in the first direction (Y-axis direction) in the second region LV2 to move between immediately above the cleaning tank 34 and immediately above the chemical liquid tank 32. When the second conveyance mechanism 72 (illustrated by a solid line) disposed in the third region LV3 is lowered to the second region LV2 (illustrated by a dotted line), the substrate 4 can be transferred in the second region LV2.

The second conveyance mechanism 72 according to the first embodiment has a function (arrow X1) of moving in the second direction (X-axis direction) in the third region LV3 and a function (arrow Z1) of moving vertically between the third region LV3 and the second region LV2. The movement range of the substrate 4 by the second conveyance mechanism 72 is included in the second region LV2 and the third region LV3 and is not included in the first region LV1. The first conveyance mechanism 70 has a function (arrow Z2) of moving vertically between the first region LV1 and the second region LV2 and a function of moving in the first direction (Y-axis direction) in the second region LV2. The movement range of the substrate 4 by the first conveyance mechanism 70 is included in the first region LV1 and the second region LV2 and is not included in the third region LV3. The vertical actuator 14 of the first conveyance mechanism 70 has a limited length D1 in the vertical direction so that the pedestal 18, the arm 16, and the substrate 4 supported by the pedestal 18 cannot be raised to the third region LV3. Therefore, the vertical actuator 14 is accommodated in the first region LV1.

The second conveyance mechanism 72 according to the first embodiment has a function of moving in the second direction not only in the third region LV3 but also in the second region LV2, and can improve the throughput.

In the example illustrated in Fig. 30, in a leftmost chemical module 7, the substrate 4 is disposed in a first region LV1 and treated in a cleaning tank 34. In a central chemical module 7, a vertical actuator 214 of the first conveyance mechanism 270 raises the substrate 4 and disposes the substrate 4 in a second region LV2. The first conveyance mechanism 270 can convey the substrate 4 in the first direction in the second region LV2 to move between immediately above the cleaning tank 34 and immediately above a chemical liquid tank 32. Since the second conveyance mechanism 272 according to the second embodiment does not have a function of being lowered to the second region LV2, the substrate 4 is not transferred in the second region LV2. In a rightmost chemical module 7, the vertical actuator 214 of the first conveyance mechanism 270 further raises the substrate 4 and disposes the substrate 4 in a third region LV3. The substrate 4 is transferred between the second conveyance mechanism 272 and the first conveyance mechanism 270 disposed in the third region LV3.

The second conveyance mechanism 272 according to the second embodiment has a function (arrow X1) of moving in the second direction in the third region LV3, but does not have a vertical movement function (arrow Z1 in Fig. 29). The movement range of the substrate 4 by the second conveyance mechanism 272 is included only in the third region LV3. The first conveyance mechanism 270 has a function (arrow Z3) of moving vertically between the second region LV2 and the third region LV3 in addition to a function (arrow Z2) of moving vertically between the first region LV1 and the second region LV2. The movement range of the substrate 4 by the first conveyance mechanism 270 is included in the first region LV1, the second region LV2, and the third region LV3. In the vertical actuator 214 of the first conveyance mechanism 270, a length D2 in the vertical direction is set to be longer than the length D1 illustrated in Fig. 29 and extends to the second region LV2 so that the substrate 4 can move vertically from the first region LV1 to the third region LV3.

In the first embodiment illustrated in Fig. 29, (1) conveyance of the substrate 4 in the first direction and (2) transfer of the substrate 4 are performed in the second region LV2, whereas in the second embodiment illustrated in Fig. 30, (1) conveyance of the substrate 4 in the first direction is performed in the second region LV2, and (2) transfer of the substrate 4 is performed in the third region LV3.

In the second embodiment, since the second conveyance mechanism 272 conveys the substrate 4 in the second direction in the third region LV3 shifted upward with respect to the second region LV2 including the movement range of the substrate 4 by the first conveyance mechanism 70, the first conveyance mechanism 70 and the second conveyance mechanism 72 can convey the substrate 4 without interfering with each other. Note that the second conveyance mechanism 272 is not limited to the case of being at a position shifted upward with respect to the region including the movement range of the substrate 4 by the first conveyance mechanism 70, and may convey the substrate 4 in the second direction in a region shifted in other directions.

In the second embodiment, since the second conveyance mechanism 272 moves only the third region LV3 in the second direction, the opening 37a illustrated in Fig. 9 or the like may be provided only in the third region LV3, and the side wall 37 may be present in the second region LV2. Therefore, contamination can be further suppressed.

The substrate processing device 200 according to the second embodiment illustrated in Fig. 30 includes the cleaning tank 34 (first tank) and the chemical liquid tank 32 (second tank) that are arranged in the first direction (Y-axis direction) and in which the substrate 4 can be disposed, the first conveyance mechanism 70 that moves the substrate 4 in the first direction, and the second conveyance mechanism 272 that moves the substrate 4 in the second direction (X-axis direction) intersecting the first direction. The cleaning tank 34 and the chemical liquid tank 32 are disposed in the first region LV1. The first conveyance mechanism 70 conveys the substrate 4 in the first direction in the second region LV2 disposed above the first region LV1. The second conveyance mechanism 272 conveys the substrate 4 in the second direction in the third region LV3 different from the second region LV2. According to such a configuration, the first conveyance mechanism 70 and the second conveyance mechanism 72 can convey the substrate 4 without interfering with each other, and the throughput can be improved.

In the substrate processing device 200 according to the second embodiment, the vertical actuator 214 (first vertical actuator) moves the substrate 4 vertically between the first region LV1 and the third region LV3 higher than the second region LV2. According to such a configuration, the vertical actuator for moving the second conveyance mechanism 272 vertically can be omitted, and the structure of the second conveyance mechanism 272 can be simplified.

In the substrate processing device 200 according to the second embodiment, the controller 101 controls the first conveyance mechanism 270 and the second conveyance mechanism 272 so as to transfer the substrate 4 in the third region LV3. According to such a configuration, even in a case where the second conveyance mechanism 272 does not have the vertical movement function, the first conveyance mechanism 270 can be raised to the third region LV3 and transfer the substrate 4.

In the substrate processing device 200 according to the second embodiment, the second conveyance mechanism 272 does not have the function of moving the substrate 4 vertically. According to such a configuration, the structure of the second conveyance mechanism 272 can be simplified.

On the other hand, according to the substrate processing device 1 according to the first embodiment illustrated in Fig. 29, since the length D1 of the vertical actuator 14 of the first conveyance mechanism 70 can be shortened, contamination caused by the vertical actuator 14 can be suppressed. Since the vertical actuator 14 is short, damage due to bending when the first conveyance mechanism 70 supports the carrier 2 and the plurality of substrates 4 is less likely to occur, and there is also an advantage in terms of strength. Furthermore, since the first conveyance mechanism 70 does not have the function of being raised to the third region LV3, there is no restriction when the second conveyance mechanism 72 moves in the third region LV3 in the second direction, and the movement control can be simplified.

### (Third Embodiment)

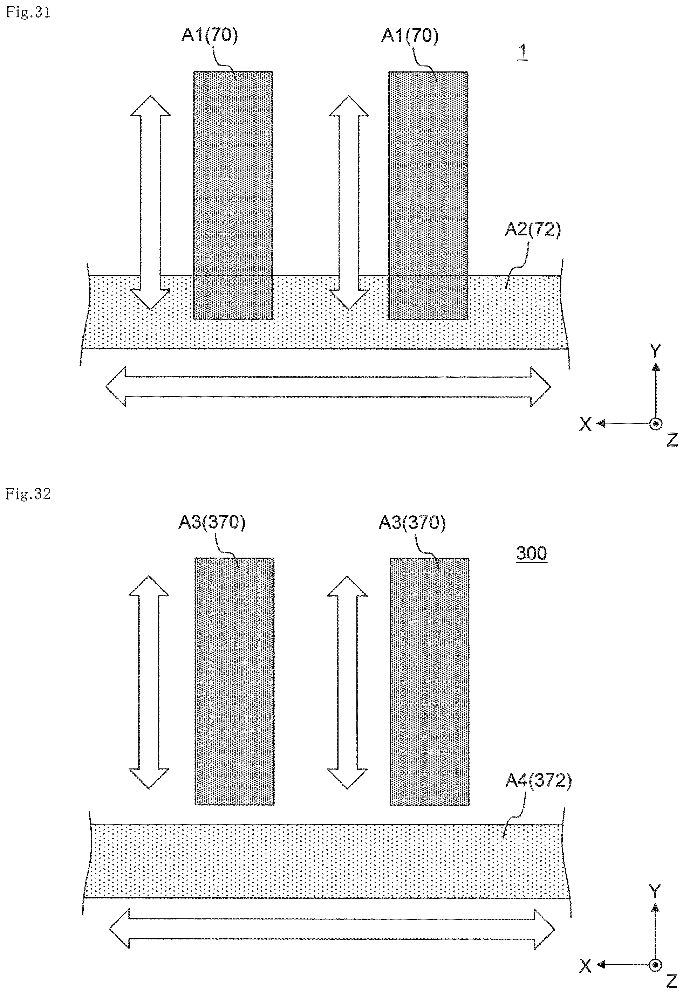

With reference to Figs. 31 and 32, a difference between the substrate processing device 1 according to the first embodiment and a substrate processing device 300 according to a third embodiment will be described. Here, the same or similar configurations as those in the first embodiment will be described with the same names and reference signs. Furthermore, description overlapping the first embodiment will be omitted.

Fig. 31 is a schematic plan view illustrating movement ranges of the first conveyance mechanism 70 and the second conveyance mechanism 72 in the substrate processing device 1 according to the first embodiment, and Fig. 32 is a schematic plan view illustrating movement ranges of a first conveyance mechanism 370 and a second conveyance mechanism 372 in the substrate processing device 300 according to the third embodiment.

In the first embodiment, the movement ranges of the substrate 4 by the first conveyance mechanism 70 and the second conveyance mechanism 72 at least partially overlap each other in plan view, whereas in the third embodiment, the movement ranges of the substrate 4 by the first conveyance mechanism 370 and the second conveyance mechanism 372 do not overlap (deviate) each other in plan view.

In the example illustrated in Fig. 31, a movement range A1 of the substrate 4 in the first direction (Y-axis direction) by the first conveyance mechanism 70 and a movement range A2 of the substrate 4 in the second direction (X-axis direction) by the second conveyance mechanism 72 overlap each other in plan view. In such an arrangement, as described above, by making the regions where the first conveyance mechanism 70 and the second conveyance mechanism 72 move the substrate 4 different in the vertical direction, it is possible to prevent the occurrence of the interference and improve the throughput.

In the example illustrated in Fig. 32, a movement range A3 of the substrate 4 in the first direction (Y-axis direction) by the first conveyance mechanism 370 and a movement range A4 of the substrate 4 in the second direction (X-axis direction) by the second conveyance mechanism 372 are shifted in the first direction and do not overlap each other in plan view. That is, the regions where the first conveyance mechanism 370 and the second conveyance mechanism 372 move the substrate 4 are different in the horizontal direction. According to such an arrangement, similarly to the first embodiment, it is possible to independently convey the substrates 4 while preventing the conveyance mechanisms 370 and 372 from interfering with each other, and to improve the throughput. While the first conveyance mechanism 370 conveys the substrate 4 in the first direction in the second region LV2, the second conveyance mechanism 372 may convey the substrate 4 in a different region having the same height as the second region LV2 or a region having a different height when conveying the substrate 4 in the second direction.

The present disclosure is not limited to a case where the region including the movement range A3 of the substrate 4 by the first conveyance mechanism 370 and the region including the movement range A4 of the substrate 4 by the second conveyance mechanism 372 are shifted in the horizontal direction such as the first direction, and may be a case where the regions are shifted in other directions (for example, an oblique direction).

As described above, the substrate processing device 300 according to the third embodiment illustrated in Fig. 32 includes the cleaning tank 34 (first tank) and the chemical liquid tank 32 (second tank) that are arranged in the first direction (Y-axis direction) and in which the substrate 4 can be disposed, the first conveyance mechanism 370 that moves the substrate 4 in the first direction, and the second conveyance mechanism 372 that moves the substrate 4 in the second direction (X-axis direction) intersecting the first direction. The cleaning tank 34 and the chemical liquid tank 32 are disposed in the first region LV1, the first conveyance mechanism 370 conveys the substrate 4 in the first direction in the second region LV2 (including the movement range A3) disposed above the first region LV1, and the second conveyance mechanism 372 conveys the substrate 4 in the second direction in a region (including the movement range A4) different from the second region LV2.

According to such a configuration, the first conveyance mechanism 370 and the second conveyance mechanism 372 can convey the substrate 4 without interfering with each other, and the throughput can be improved.

On the other hand, according to the substrate processing device 1 of the first embodiment illustrated in Fig. 31, since the movement range A1 of the first conveyance mechanism 70 and the movement range A2 of the second conveyance mechanism 72 at least partially overlap, the footprint of the substrate processing device 1 including the chemical module 7 can be reduced. The second conveyance mechanism 72 conveys the substrate 4 in the second direction in the third region LV3 higher than the second region LV2, so that the height of the casing 20 can be increased and the opening 37a can be disposed above, and cross-contamination between modules can be suppressed.

### (Fourth Embodiment)

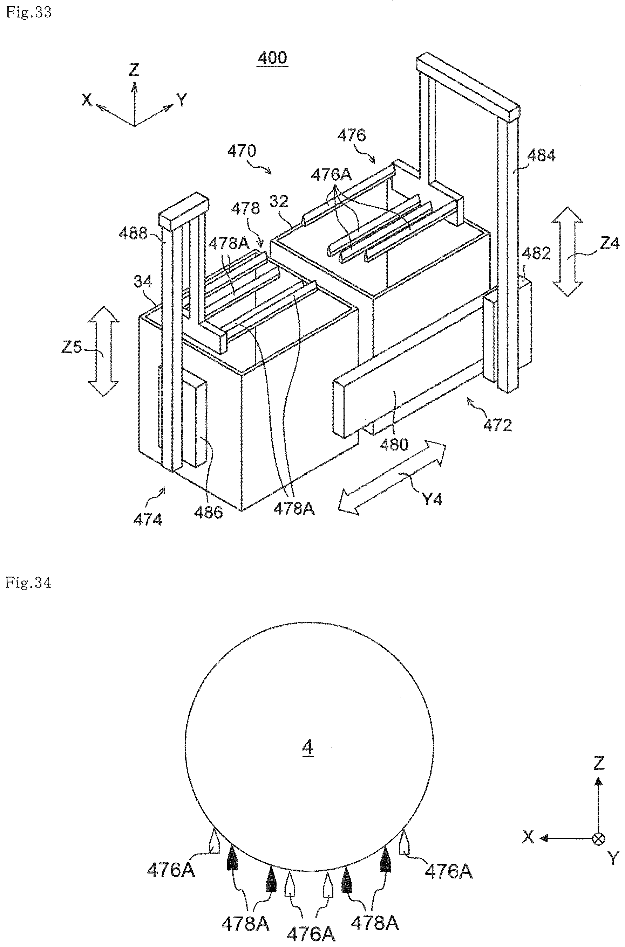

A difference between the substrate processing device 1 according to the first embodiment and a substrate processing device 400 according to a fourth embodiment will be described with reference to Figs. 33, 34, and 35A to 35D. Here, the same or similar configurations as those in the first embodiment will be described with the same names and reference signs. Furthermore, description overlapping the first embodiment will be omitted.

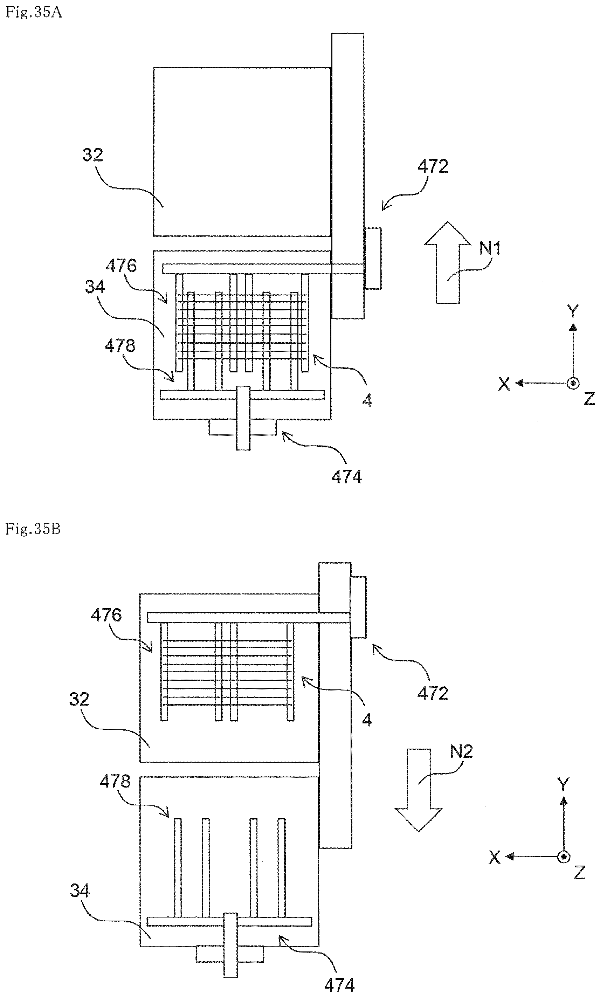

Fig. 33 is a schematic perspective view illustrating a first conveyance mechanism 470 in the substrate processing device 400 according to the fourth embodiment, and Fig. 34 is a schematic front view illustrating a transfer state of a substrate 4 by two first conveyance sections 472 and 474. Figs. 35A to 35D are schematic plan views illustrating transfer operation of the substrate 4 by the two first conveyance sections 472 and 474, respectively.

While the first conveyance mechanism 70 includes one first conveyance section 11 in the first embodiment, the first conveyance mechanism 470 includes the two first conveyance sections 472 and 474 in the fourth embodiment, which is a difference therebetween.

As illustrated in Fig. 33, the first conveyance mechanism 470 includes the first conveyance section 472 and the first conveyance section 474.

Both of the first conveyance sections 472 and 474 are movable while holding the substrate 4, and the first conveyance section 472 includes a chuck 476 and the first conveyance section 474 includes a chuck 478 as a portion for holding the substrate 4.

The chucks 476 and 478 include a plurality of arms 476A and 478A, respectively, that can support the substrate 4 from below and are configured in a comb shape. In the example illustrated in Figs. 33 and 34, the number of arms 476A and 478A is four each.

As illustrated in Fig. 33, one first conveyance section 472 includes a horizontal actuator 480, a vertical actuator 482, and a coupling arm 484.

The horizontal actuator 480 is an actuator that enables the chuck 476 to move in the Y-axis direction, which is the horizontal direction (arrow Y4). The vertical actuator 482 is an actuator that enables the chuck 476 to move in the Z-axis direction which is the vertical direction (arrow Z4). The coupling arm 484 is an arm that couples the chuck 476 and the vertical actuator 482.

The other first conveyance section 474 includes a vertical actuator 486 and a coupling arm 488. The first conveyance section 474 does not include a horizontal actuator.

The vertical actuator 486 is an actuator that enables the chuck 478 to move in the Z-axis direction which is the vertical direction (arrow Z5). The coupling arm 488 is an arm that couples the chuck 478 and the vertical actuator 486.

The first conveyance section 472 having a vertical conveyance function and a horizontal conveyance function has a function of immersing the plurality of substrates 4 held by the chuck 476 in a chemical liquid tank 32 and a function of moving the plurality of substrates 4 between an upper position of the chemical liquid tank 32 and an upper position of a cleaning tank 34.

The first conveyance section 474 having the vertical conveyance function has a function of immersing the plurality of substrates 4 held by the chuck 478 in the cleaning tank 34.

As illustrated in Fig. 34, the four arms 476A of the chuck 476 and the four arms 478A of the chuck 478 are disposed at positions shifted from each other in the X-axis direction. Therefore, when the chucks 476 and 478 move vertically, respectively, or when the chuck 476 moves horizontally, the arms 476A and 478A do not interfere with each other. The chucks 476 and 478 can operate independently in a state where the substrate 4 is not held, and can transfer the substrate 4 in a state where either one of the chucks holds the substrate 4.

When the substrate 4 is transferred, the chuck holding the substrate 4 may be lowered or the chuck not holding the substrate 4 may be raised in a state in which the chuck holding the substrate 4 is disposed above and the chuck not holding the substrate 4 is disposed below, of the two chucks 476 and 478.

The operation of the first conveyance mechanism 470 having the above-described configuration will be described with reference to Figs. 35A to 35D.

In a state illustrated in Fig. 35A, both the chucks 476 and 478 are at positions overlapping the cleaning tank 34 in plan view. In a state where the chuck 476 is located in the second region LV2 and the chuck 478 is located below the second region LV2 (for example, the first region LV1), the chuck 476 located above receives the plurality of substrates 4 from a second conveyance mechanism 72 (not illustrated), whereby the state illustrated in Fig. 35A is obtained. The first conveyance section 472 that has received the substrate 4 horizontally moves the chuck 476 and the substrate 4 in the Y-axis direction toward the upper position of the chemical liquid tank 32 (arrow N1).

In a state illustrated in Fig. 35B, the chuck 476 of the first conveyance section 472 is disposed at an upper position of the chemical liquid tank 32. The first conveyance section 472 immerses the substrate 4 in the chemical liquid in the chemical liquid tank 32 by lowering the chuck 476 and the substrate 4. When the treatment in the chemical liquid tank 32 is completed, the first conveyance section 472 raises the chuck 476 and the substrate 4 and horizontally moves the chuck and the substrate in the Y-axis direction toward the upper position of the cleaning tank 34 (arrow N2).

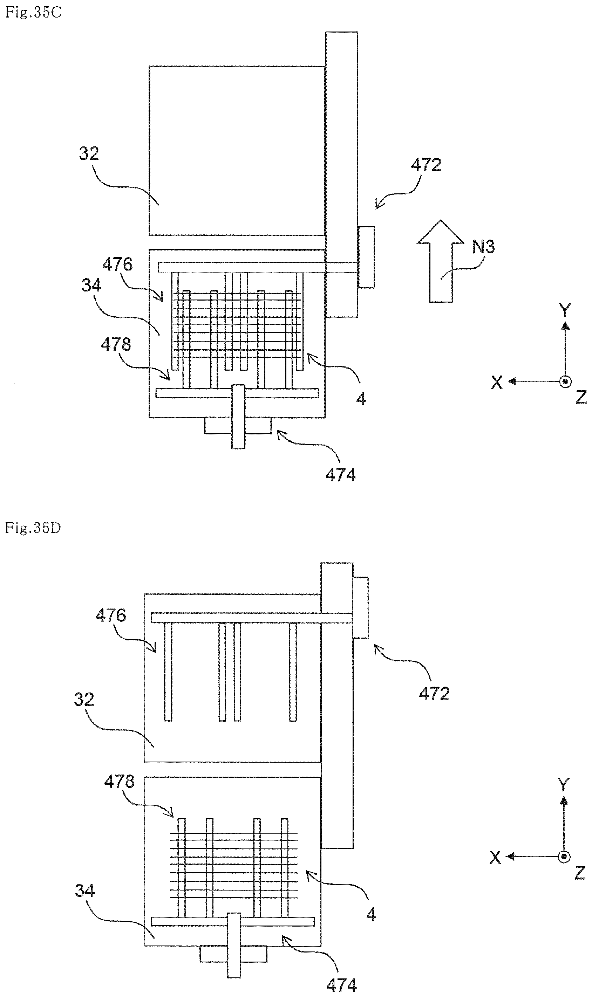

In a state illustrated in Fig. 35C, the chuck 476 of the first conveyance section 472 is located above the cleaning tank 34. While the chuck 476 is located in the second region LV2, the chuck 478 of the first conveyance section 474 is retracted below the second region LV2, and thus does not interfere with the substrate 4. When the first conveyance section 472 lowers the chuck 476 or the first conveyance section 474 raises the chuck 478, the plurality of substrates 4 is transferred from the chuck 476 to the chuck 478. The chuck 476 after transferring the substrate 4 moves in the Y-axis direction toward the upper position of the chemical liquid tank 32 (arrow N3) and retracts from the upper position of the cleaning tank 34.

In a state illustrated in Fig. 35D, the chuck 478 of the first conveyance section 474 holds the plurality of substrates 4, and the substrate 4 is immersed in the cleaning water of the cleaning tank 34 by lowering the chuck 478 and the substrate 4 by the first conveyance section 474. When the treatment in the cleaning tank 34 is completed, the first conveyance section 474 raises the chuck 478 and the substrate 4. Thereafter, the first conveyance section 474 transfers the plurality of substrates 4 to a second conveyance section 48 (not illustrated), and the substrates 4 transferred to the second conveyance section 48 are conveyed along the X-axis direction.

By combining the two first conveyance sections 472 and 474 in this manner, it is possible to perform the treatment in the chemical liquid tank 32 by the first conveyance section 472, to transfer the substrate 4 between the first conveyance sections 472 and 474, and to perform the treatment in the cleaning tank 34 by the first conveyance section 474.

As described above, in the substrate processing device 400 according to the fourth embodiment, the two first conveyance sections 472 and 474 are provided, one first conveyance section 474 includes the chuck 478 (first chuck) that is movable vertically and is disposed in the cleaning tank 34 (first tank) in a state of holding the substrate 4, the other first conveyance section 472 includes the chuck 476 (second chuck) that is movable vertically and is disposed in the chemical liquid tank 32 (second tank) in a state of holding the substrate 4, the chuck 476 is movable between the upper position of the cleaning tank 34 and the upper position of the chemical liquid tank 32, and the chuck 478 and the chuck 476 are configured to be able to transfer the substrate 4 to each other.

According to such a configuration, by using the two first conveyance sections 472 and 474 in combination, the operating rate in each of the cleaning tank 34 and the chemical liquid tank 32 can be improved, and the throughput of the substrate processing device 400 can be improved.

Note that, although the case where the first conveyance section 472 has the horizontal conveyance function and the first conveyance section 474 does not have the horizontal conveyance function has been described, the present disclosure is not limited to such a case, and at least one of the two first conveyance sections 472 and 474 may have the horizontal conveyance function. That is, it is sufficient that at least one of the chuck 476 and the chuck 478 is movable between the upper position of the cleaning tank 34 and the upper position of the chemical liquid tank 32.

The arms 476A and 478A of the chucks 476 and 478 are not limited to the comb shape, and may have any other shape as long as the plurality of substrates 4 can be held and transferred.

### (Fifth Embodiment)

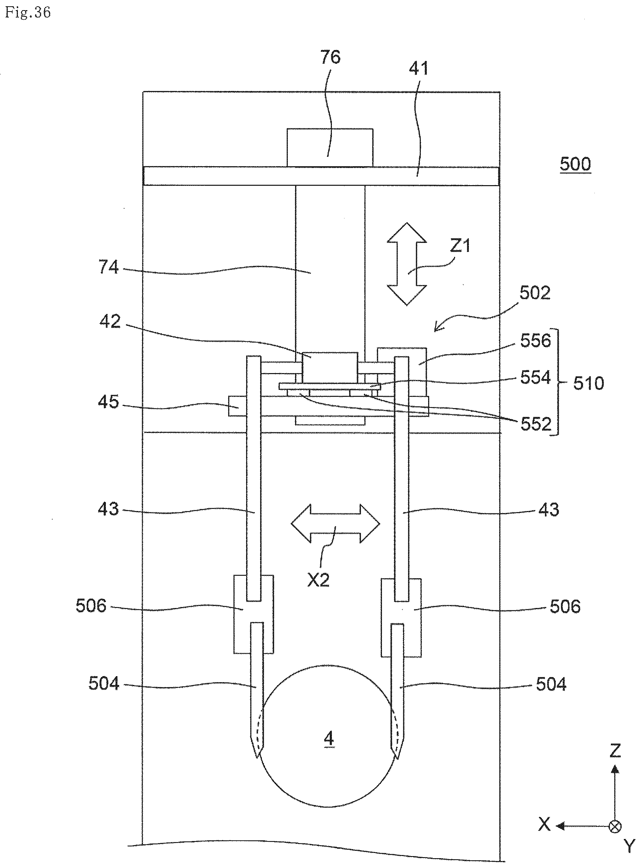

A difference between the substrate processing device 1 according to the first embodiment and a substrate processing device 500 according to a fifth embodiment will be described with reference to Figs. 36 to 46. Here, the same or similar configurations as those in the first embodiment will be described with the same names and reference signs. Furthermore, description overlapping the first embodiment will be omitted.

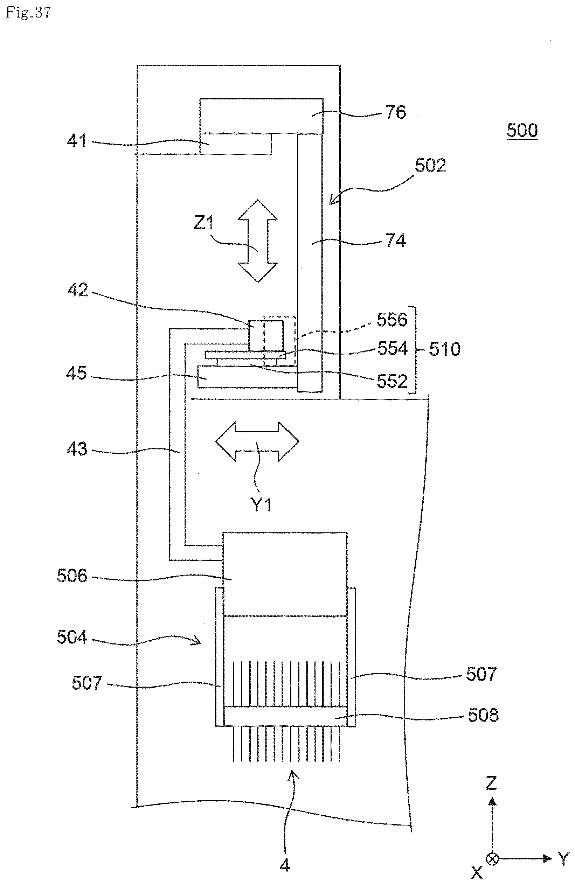

Figs. 36 and 37 are a schematic front view and a schematic side view, respectively, illustrating a peripheral structure of a second conveyance section 502 (second conveyance mechanism) in the substrate processing device 500 according to the fifth embodiment.

In the first embodiment, the second conveyance section 48 holds the carrier 2 holding the plurality of substrates 4, whereas in the fifth embodiment, the second conveyance section 502 directly holds a plurality of substrates 4, that is, a so-called "carrier-less" configuration is different. The fifth embodiment is further different from the first embodiment in that a position adjustment mechanism 510 for adjusting a holding position of the substrate 4 by the second conveyance section 502 is provided.

As illustrated in Fig. 36, the second conveyance section 502 includes a chuck portion 504, a coupling block 506, and the position adjustment mechanism 510 in addition to a second actuator 41, a chuck actuator 42, a coupling arm 43, and a holding block 45.

The chuck portion 504 is a pair of members for directly gripping the plurality of substrates 4, and is attached to the coupling block 506. The coupling block 506 is a block for coupling the chuck portion 504 to the coupling arm 43. The position adjustment mechanism 510 is a mechanism for adjusting the holding position of the substrate 4 by the chuck portion 504.

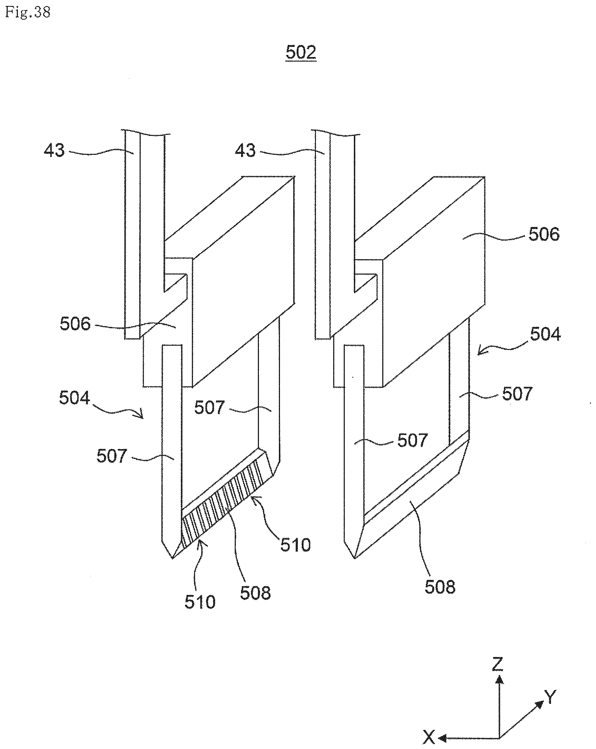

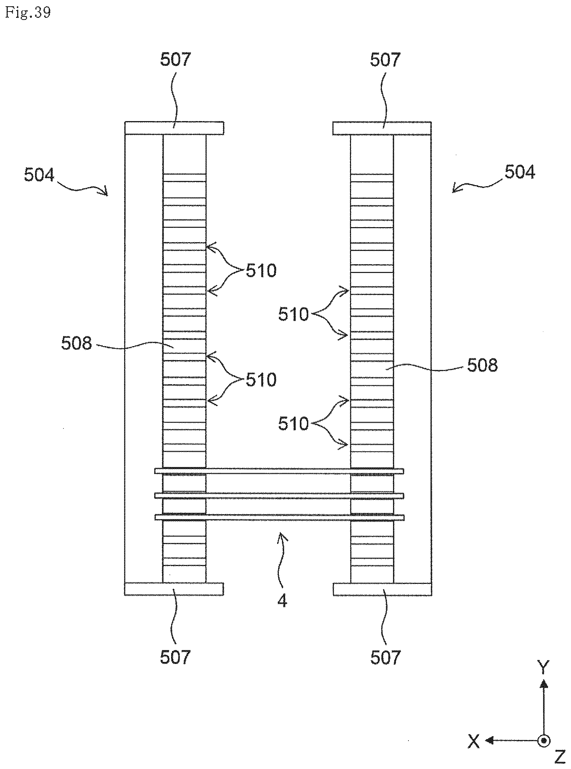

Figs. 38 and 39 are a schematic perspective view and a schematic plan view of the chuck portion 504 of a carrier-less type, respectively.

As illustrated in Figs. 38 and 39, each of the chuck portions 504 includes a pair of chuck arms 507 and a holding portion 508.

The chuck arms 507 are a pair of arms extending so as to couple the coupling block 506 and the holding portion 508. The holding portion 508 is a portion for directly holding the substrate 4, and is provided with a plurality of holding grooves 510.

As illustrated in Fig. 39, the plurality of holding grooves 510 is provided in each of the holding portions 508, and one substrate 4 can be held by a pair of left and right holding grooves 510 aligned in position in the Y direction. Fig. 39 illustrates a state in which three substrates 4 are held by the plurality of holding grooves 510.

The second conveyance section 502 having the above configuration directly transfers the substrate 4 to and from a first conveyance mechanism. That is, the first conveyance mechanism is also of a carrier-less type, and the first conveyance mechanism of a carrier-less type will be described below.

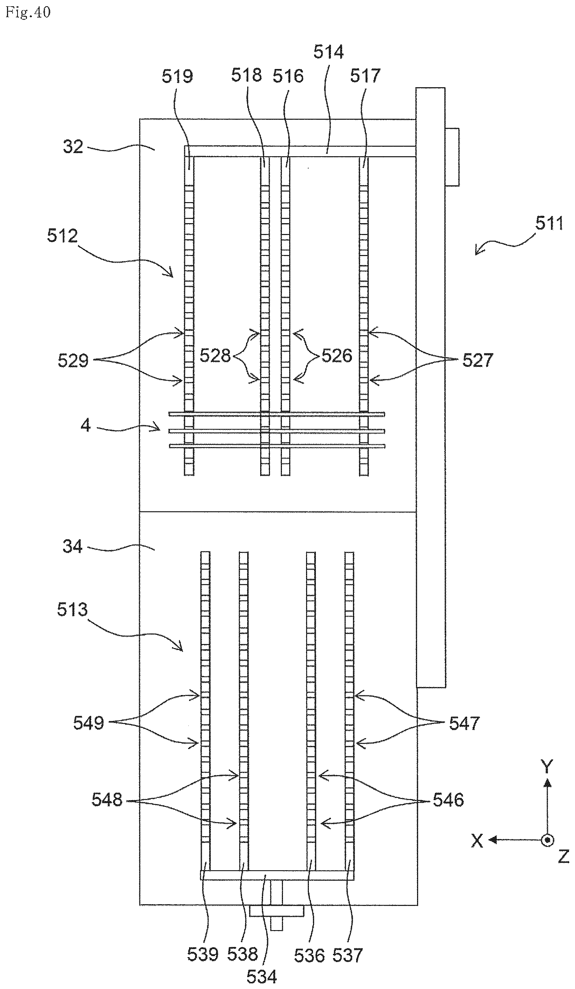

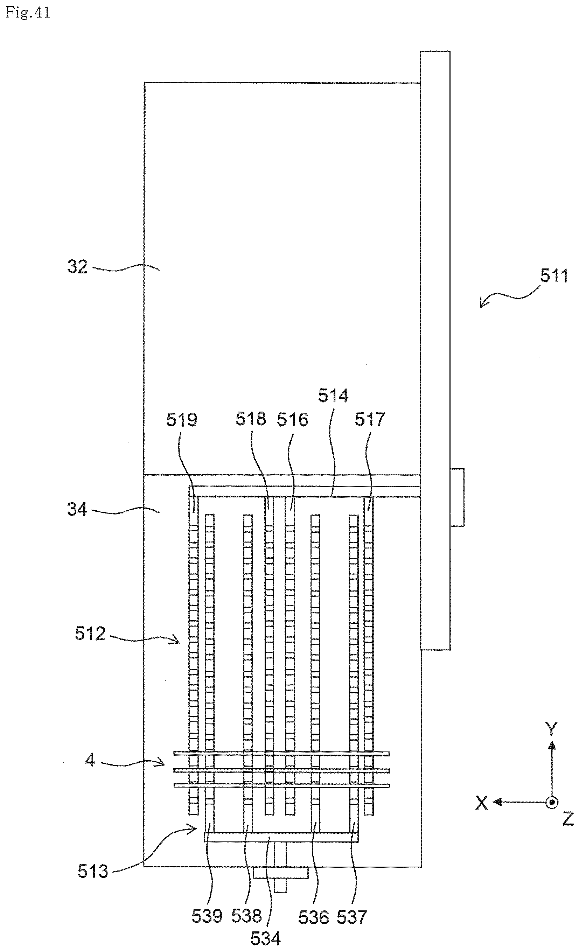

Figs. 40 and 41 are schematic plan views illustrating a first conveyance mechanism 511 according to the fifth embodiment.

As illustrated in Fig. 40, the first conveyance mechanism 511 includes a first conveyance section 512 and a first conveyance section 513.

Both the first conveyance sections 512 and 513 are members capable of directly holding the substrate 4, and each has a vertical movement function. The first conveyance section 512 further has a function of moving in the Y direction between a chemical liquid tank 32 and a cleaning tank 34. Unlike the first conveyance section 512, the first conveyance section 513 does not have a function of moving in the Y direction, and is disposed on the cleaning tank 34.

The first conveyance section 512 includes a movement arm 514 and four arms 516, 517, 518, and 519.

The movement arm 514 is an arm driven in each of the Y direction and the Z direction by an actuator. Each of the arms 516, 517, 518, and 519 is an arm that directly holds the substrate 4, and is held by the movement arm 514. The arms 516, 517, 518, and 519 each extend in the Y direction, and are provided with holding grooves 526, 527, 528, and 529. One substrate 4 can be held from below by a set of the holding grooves 526, 527, 528, and 529 aligned in position in the Y direction. Fig. 40 illustrates a state in which three substrates 4 are held by three sets of the holding grooves 526, 527, 528, and 529.

The first conveyance section 513 includes a movement arm 534 and four arms 536, 537, 538, and 539.

The movement arm 534 is an arm driven in the Z direction by an actuator. Each of the arms 536, 537, 538, and 539 is an arm that directly holds the substrate 4, and is held by the movement arm 534. The arms 536, 537, 538, and 539 each extend in the Y direction, and are provided with holding grooves 546, 547, 548, and 549. One substrate 4 can be held from below by a set of the holding grooves 546, 547, 548, and 549 aligned in position in the Y direction.

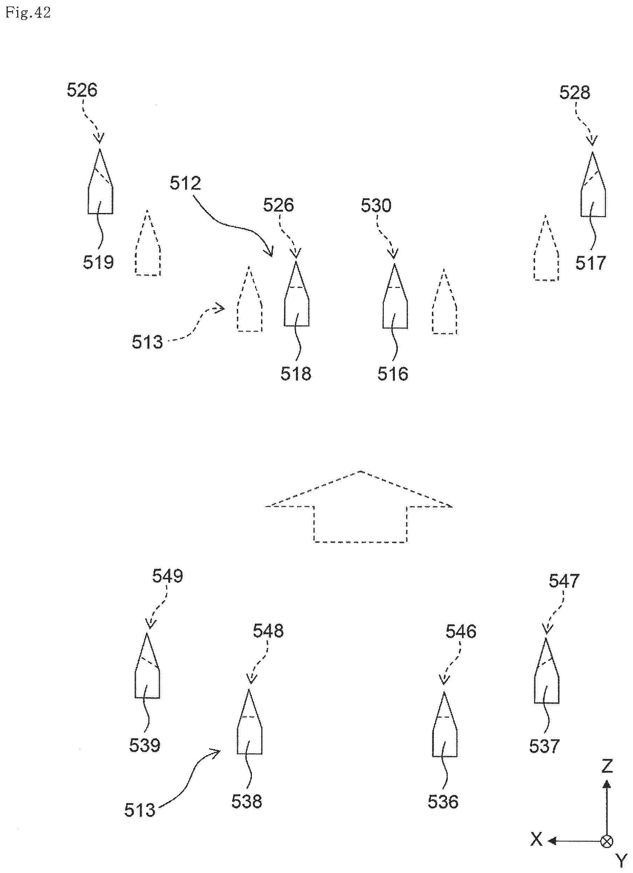

As illustrated in Fig. 40, the positions of a total of the eight arms 516, 517, 518, 519, 536, 537, 538, and 539 in the two first conveyance sections 512 and 513 are adjusted such that the positions in the X direction do not overlap with each other. According to such an arrangement, as illustrated in Fig. 41, even in a case where the two first conveyance sections 512 and 513 are located above the cleaning tank 34, the eight arms 516, 517, 518, 519, 536, 537, 538, and 539 do not overlap each other and can move vertically independently. As illustrated in Fig. 42, the first conveyance section 512 and the second conveyance section 513 can independently move along the Z direction to transfer the substrate 4.

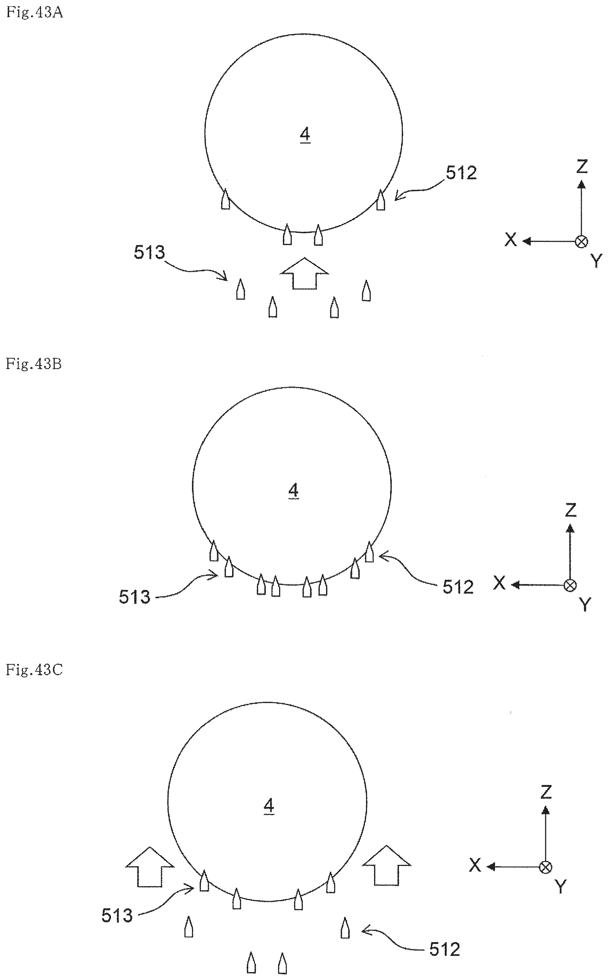

Next, a method of transferring the substrate 4 between the two first conveyance sections 512 and 513 will be described with reference to schematic front views of Figs. 43A to 43C.

In Fig. 43A, the first conveyance section 512 holds the substrate 4. In this state, the first conveyance section 513 located below the first conveyance section 512 is raised toward the first conveyance section 512. As described above, since the four arms of the first conveyance section 512 and the four arms of the first conveyance section 513 are disposed to be shifted in the X direction, they do not interfere with each other, and as illustrated in Fig. 43B, the first conveyance section 513 comes into contact with the substrate 4 held by the first conveyance section 512 from below.

When the first conveyance section 513 is further raised, as illustrated in Fig. 43C, the holding of the substrate 4 by the first conveyance section 512 is released, and the first conveyance section 513 independently holds the substrate 4. In this manner, the substrate 4 can be transferred from the first conveyance section 512 to the first conveyance section 513.

On the other hand, when the substrate 4 is transferred from the first conveyance section 513 to the first conveyance section 512, the operation in the order opposite to the operation in Figs. 43A to 43C may be executed. That is, the first conveyance section 512 located below the first conveyance section 513 is raised with respect to the first conveyance section 513 holding the substrate 4, whereby the holding of the substrate 4 by the first conveyance section 513 is released, and the second conveyance section 512 independently holds the substrate 4. In this manner, the substrate 4 can be transferred from the first conveyance section 513 to the first conveyance section 512.

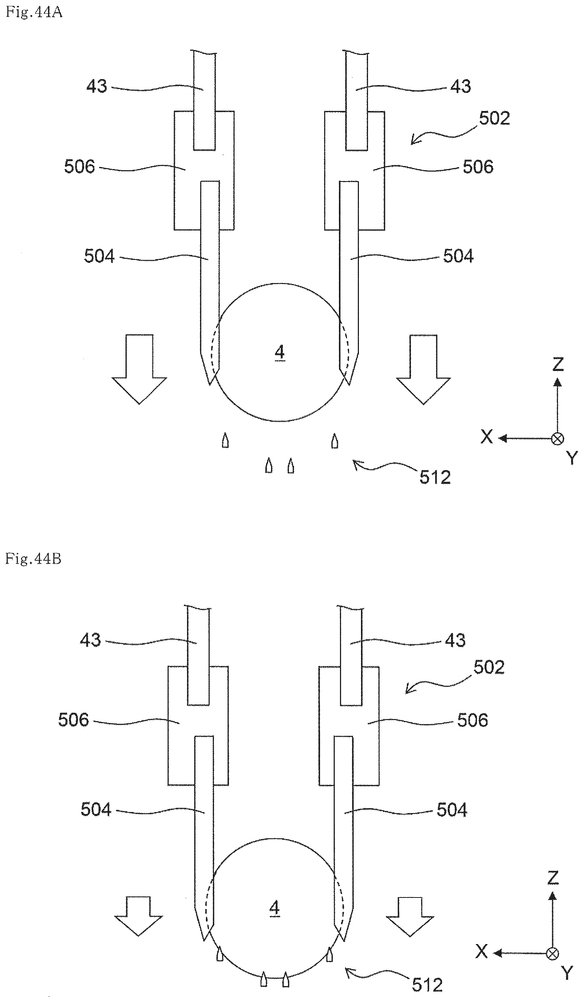

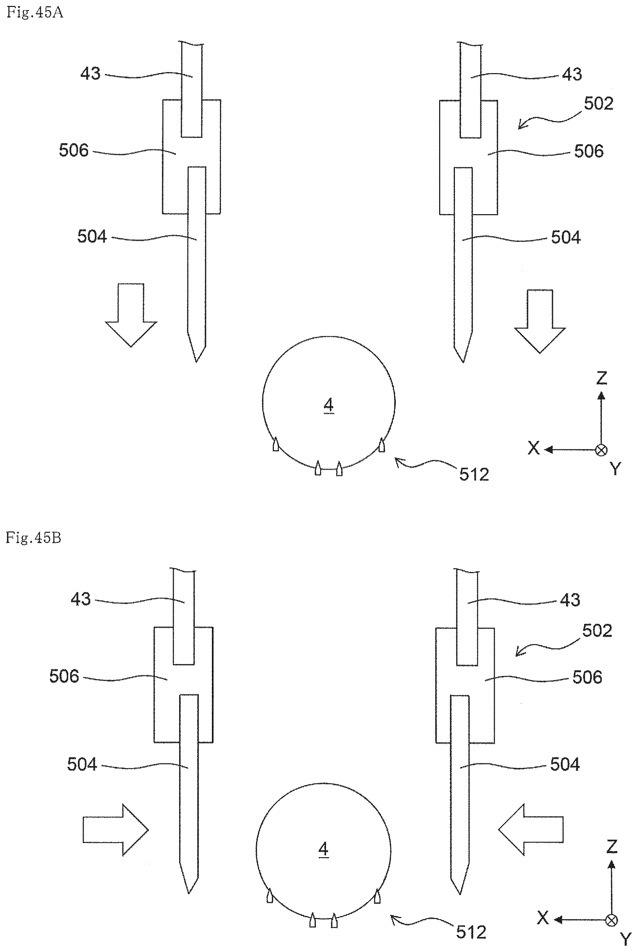

Next, a method of transferring the substrate 4 between the first conveyance sections 512 and 513 (first conveyance mechanism 511) and the second conveyance section 502 (second conveyance mechanism) will be described with reference to schematic front views of Figs. 44A to 44C and Figs. 45A to 45D.

Figs. 44A to 44C illustrate a method of transferring the substrate 4 from the second conveyance section 502 to the first conveyance section 512.

In Fig. 44A, in a state where the chuck portion 504 of the second conveyance section 502 holds the substrate 4, the second conveyance section 502 is lowered toward the first conveyance section 512 located below.

As illustrated in Fig. 44B, a lower end portion of the substrate 4 held by the chuck portion 504 comes into contact with the holding grooves of the four arms of the first conveyance section 512. When the second conveyance section 502 is further slightly lowered in this state, the holding of the substrate 4 by the chuck portion 504 is released, and the first conveyance section 512 independently holds the substrate 4.

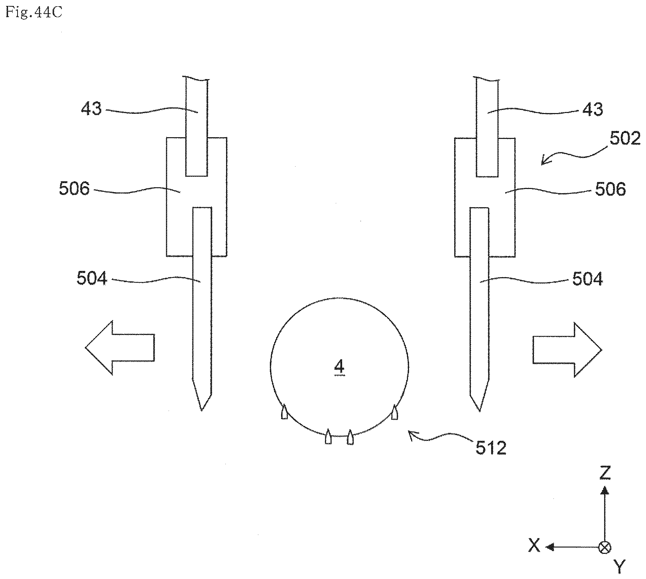

As illustrated in Fig. 44C, thereafter, the pair of chuck portions 504 is driven to be separated from each other along the X direction.

In this manner, the substrate 4 can be transferred from the second conveyance section 502 to the first conveyance section 512. Also for the first conveyance section 513, the substrate 4 can be transferred from the second conveyance section 502 to the first conveyance section 513 by a similar method.

Figs. 45A to 45D illustrate a method of transferring the substrate 4 from the first conveyance section 512 to the second conveyance section 502.

As illustrated in Fig. 45A, in a state where the first conveyance section 512 holds the substrate 4, the second conveyance section 502 located above the first conveyance section 512 is lowered toward the first conveyance section 512. The pair of arms 504 of the first conveyance section 512 is in an open state and does not interfere with the substrate 4.

As illustrated in Fig. 45B, when the chuck portion 504 is lowered to a height position at which the substrate 4 can be held, the pair of chuck portions 504 is driven in a closing direction.

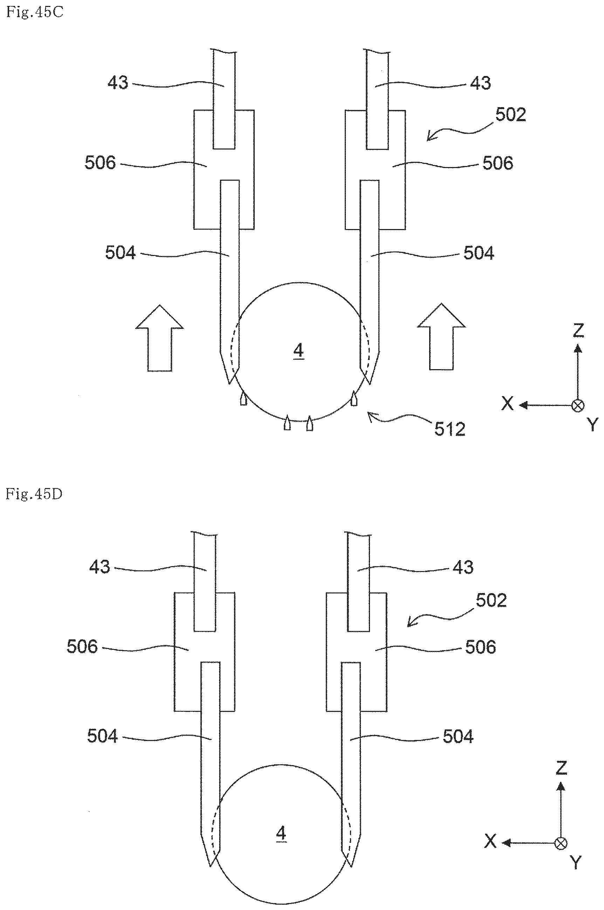

As illustrated in Fig. 45C, the pair of chuck portions 504 sandwiches the substrate 4 from both sides, and engages the substrate 4 with the holding groove 508 illustrated in Figs. 38 and 39. In this state, when the second conveyance section 502 is raised, the holding of the substrate 4 by the first conveyance section 512 is released. As illustrated in Fig. 45D, the second conveyance section 502 alone holds the substrate 4, and the substrate 4 can be transferred from the first conveyance section 512 to the second conveyance section 502. For the first conveyance section 513, the substrate 4 can be transferred from the first conveyance section 513 to the second conveyance section 502 by a similar method.

In the operation illustrated in Figs. 44A to 44C and Figs. 45A to 45D, it is necessary to align the holding grooves of the first conveyance sections 512 and 513 and the holding grooves of the second conveyance section 502 in the Y direction in order to reliably transfer the substrate 4. On the other hand, in a case where the plurality of chemical modules 7 is coupled in the X direction as illustrated in Fig. 1 and the like, the positions of the first conveyance sections 512 and 513 in the Y direction for each module may be shifted, and in a case where the shift amount is large, the positions of the holding grooves of the first conveyance sections 512 and 513 and the holding grooves of the second conveyance section 502 in the Y direction may not match, and the transfer of the substrate 4 may fail.

Such a problem is less likely to occur in a case where the carrier 2 holding the plurality of substrates 4 is conveyed as in the first embodiment since it is not necessary to align the holding grooves with each other, and is significantly generated in the case of a carrier-less type directly holding the substrate 4 as in the fifth embodiment.

Therefore, the substrate processing device 500 according to the fifth embodiment is provided with the position adjustment mechanism 510 capable of adjusting the holding position of the substrate 4 by the second conveyance section 502 in the Y direction.

The position adjustment mechanism 510 illustrated in Figs. 36 and 37 includes a slider 552, a slide plate 554, and a slide drive section 556 as members for adjusting the holding position of the substrate 4 by the chuck portion 504 in the Y direction.

The slider 552 is a member for sliding the slide plate 554 in the Y direction, and is fixed to an upper surface of the holding block 45 in a state of extending in the Y direction. In the example illustrated in Fig. 36, a pair of the sliders 552 is provided at intervals in the X direction.

The slide plate 554 is a member that slides in the Y direction along the slider 552, and is driven by the slide drive section 556. The chuck actuator 42 is fixed to an upper surface of the slide plate 554.

The slide drive section 556 is a member for slidably driving the slide plate 554, and includes, for example, a mechanism (motor, belt, or the like) that converts a rotational force by a motor into a linear driving force in the Y direction. As the slide drive section 556, any configuration may be used as long as the slide plate 554 can be slidably driven in each of the +Y direction and the -Y direction.

According to the above configuration, while the components including the chuck portion 504 and the position adjustment mechanism 510 are integrally movable vertically (arrow Z1) and the chuck portion 504 is openable and closeable (arrow X2), the position of the chuck portion 504 in the Y direction can be adjusted by driving the slide plate 554 (arrow Y1).

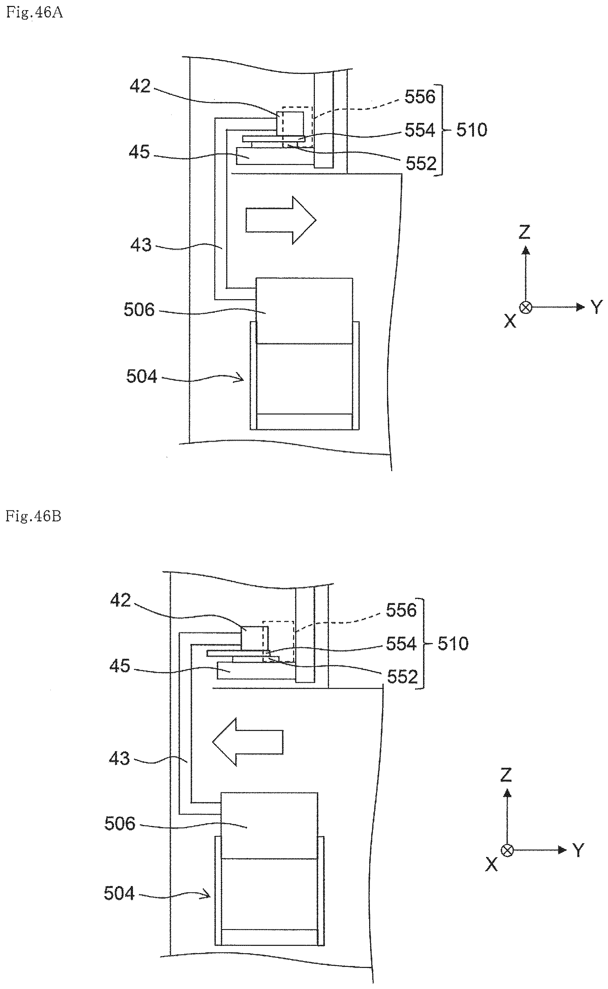

Figs. 46A and 46B are schematic side views illustrating a state in which the chuck portion 504 is slid in the Y direction.

Fig. 46A illustrates a state in which the slide plate 554 is moved in the +Y direction and the chuck portion 504 is moved in the +Y direction. Fig. 46B illustrates a state in which the slide plate 554 is moved in the -Y direction and the chuck portion 504 is moved in the -Y direction. In this manner, the holding position of the substrate 4 by the chuck portion 504 can be adjusted in the Y direction.

In the case of using the position adjustment mechanism 510, when the plurality of chemical modules 7 is coupled as illustrated in Fig. 1, the positions of the first conveyance sections 512 and 513 in the Y direction for each module are calculated, and a position adjustment amount of the second conveyance section 502 by the position adjustment mechanism 510 is determined in advance so as to match the calculated positions. For example, a first adjustment amount may be determined for a certain chemical module 7, and a second adjustment amount different from the first adjustment amount may be determined for another chemical module 7.

When transferring the substrate 4 between the second conveyance section 502 and the first conveyance sections 512 and 513 in the chemical module 7, the controller 101 adjusts the position of the second conveyance section 502 in the Y direction on the basis of the position adjustment amount corresponding to the chemical module 7 and transfers the substrate 4.

Therefore, the substrate 4 can be transferred in a state where the positions of the holding grooves of the second conveyance section 502 and the first conveyance sections 512 and 513 in the Y direction are aligned. Therefore, it is possible to accurately perform transfer of the substrate 4, and it is possible to reduce production stop due to transfer failure of the substrate 4, waste loss of the damaged substrate 4, and the like. Furthermore, when the chemical modules 7 are coupled to each other, it is not necessary to increase dimensional accuracy related to position adjustment in the Y direction, and the chemical modules 7 can be coupled to each other at an early stage. Therefore, the time required for assembling and installing the substrate processing device 1 can be shortened. Furthermore, even if there is an individual difference in shape or size for each chemical module 7, the individual difference can be absorbed.

As described above, in the substrate processing device 500 according to the fifth embodiment, the second conveyance section 502 (second conveyance mechanism) includes the position adjustment mechanism 510 for adjusting the position of holding the substrate 4. According to such a configuration, the substrate 4 can be transferred between the first conveyance sections 512 and 513 and the second conveyance section 502 with high accuracy, which leads to an improvement in throughput.

Note that, in the fifth embodiment, the case where the second conveyance section 502 includes the position adjustment mechanism 510 has been described, but the present disclosure is not limited to such a case. For example, the first conveyance sections 512 and 513 (first conveyance mechanism 511) may include the position adjustment mechanism. That is, the first conveyance mechanism 511 or the second conveyance mechanism may include the position adjustment mechanism.

Since the first conveyance section 512 illustrated in Fig. 40 already has the movement function in the Y direction, if the position adjustment amount of the first conveyance section 512 in the Y direction for each module is determined in advance, the first conveyance section 512 can have the position adjustment function. On the other hand, since the first conveyance section 513 does not have the movement function in the Y direction, if the movement mechanism in the Y direction is separately added and the position adjustment amount of the first conveyance section 513 in the Y direction for each module is determined in advance, the first conveyance section 513 can have the position adjustment function. In a case where the movement mechanism in the Y direction is added to the first conveyance section 513, for example, the movement distance and movement space in the Y direction may be secured by disposing the movement mechanism at a position shifted in the X direction instead of a position shifted in the Y direction with respect to the cleaning tank 34 as illustrated in Fig. 40.

In the substrate processing device 500 according to the fifth embodiment, the position adjustment mechanism 510 has a function of adjusting the conveyance position of the substrate 4 in the Y direction (first direction). According to such a configuration, even in a case where the plurality of chemical modules 7 is coupled in the X direction and the positional displacement in the Y direction is likely to occur, the substrate 4 can be transferred between the first conveyance sections 512 and 513 and the second conveyance section 502 with high accuracy.

Note that, in the fifth embodiment, the case where the position adjustment mechanism 510 adjusts the position in the Y direction has been described, but the present disclosure is not limited to such a case. The position adjustment may be performed in a direction different from the Y direction. Note that, in a case where the position is adjusted in a plurality of directions, a plurality of the slide plates may be provided as necessary. Furthermore, the present disclosure is not limited to linear position adjustment, and may have a function of performing adjustment by rotating in a horizontal plane.

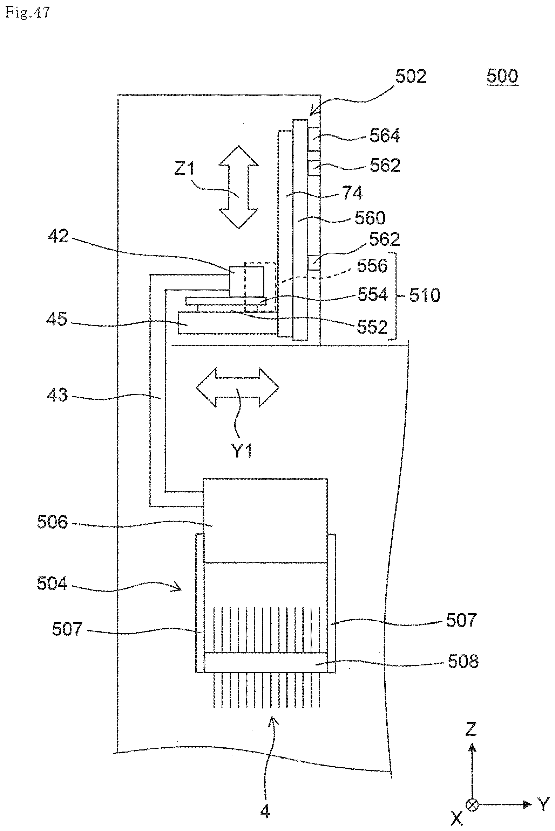

Fig. 47 is a schematic side view illustrating a peripheral structure of a second conveyance section 502 according to a modification of the fifth embodiment. In the fifth embodiment, the second actuator 41 is provided above the holding block 45, but in the modification illustrated in Fig. 47, a second actuator 564 is provided on a back side of a vertical rail 74.

The second conveyance section 502 illustrated in Fig. 47 includes a coupling plate 560, a pair of rails 562, and the second actuator 564.

The coupling plate 560 is coupled to the back side of the vertical rail 74 and supports the vertical rail 74. The pair of rails 562 are rails extending in the X-axis direction, are provided at intervals in the Z-axis direction, and support the coupling plate 560 so as to be able to travel in the X-axis direction. The second actuator 564 drives the coupling plate 560 along the rails 562 in the X-axis direction.

According to the configuration illustrated in Fig. 47, the movement mechanism (coupling plate 560, rails 562, and second actuator 564) in the X-axis direction and the movement mechanism (vertical rail 74, chuck actuator 42, position adjustment mechanism 510, and the like) in the Z-axis direction can be disposed at the same height in the Z-axis direction. Therefore, as compared with the substrate processing device 500 according to the fifth embodiment, the height of the substrate processing device 500 can be reduced, and the substrate processing device 500 can be further downsized.

Note that the configuration is not limited to the configuration illustrated in Fig. 47, and similar effects can be obtained as long as the movement mechanism that moves the chuck portion 504 in the Z-axis direction and the movement mechanism that moves the chuck portion 504 in the X-axis direction are at the same height position.

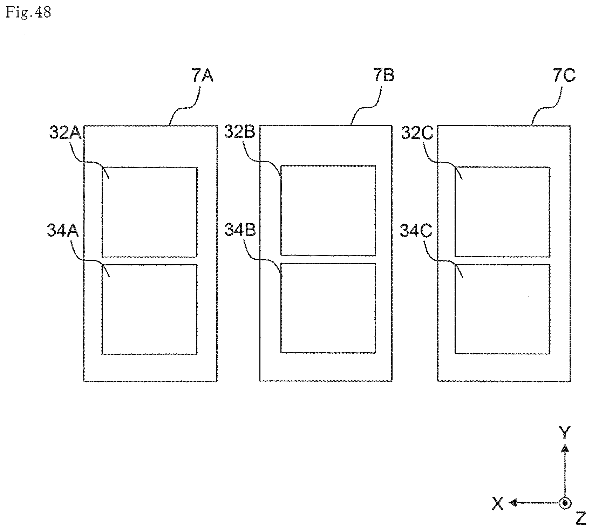

Note that, in the first to the fifth embodiments, the case where the cleaning tank 34 and the chemical liquid tank 32 are provided as two tanks (first tank, second tank) has been described, but the present disclosure is not limited to such a case. For example, as illustrated in the schematic plan view of Fig. 48, different combinations of tanks may be used in each of the chemical modules 7A, 7B, and 7C. In the example illustrated in Fig. 48, a first tank 34A of the chemical module 7A is a cleaning tank, and a second tank 32A is a chemical liquid tank. However, both a first tank 34B and a second tank 32B of the chemical module 7B are chemical liquid tanks, and both a first tank 34C and a second tank 32C of the chemical module 7C are one-bath treatment tanks. The one-bath treatment tank is a tank having both functions of the chemical liquid treatment and the cleaning treatment, and has a function of supplying and draining chemical liquid and a function of supplying and draining cleaning liquid.

The chemical liquids used in the first tank 34B and the second tank 32B of the chemical module 7B may be the same or different, and the chemical liquids used in the first tank 34C and the second tank 32C of the chemical module 7C may also be the same or different.

As in the layout illustrated in Fig. 48, the combination of the first tank and the second tank is not limited to the cleaning tank 34 and the chemical liquid tank 32, and various combinations can be adopted. Any one of a chemical liquid tank, a cleaning tank, and a one-bath treatment tank may be used for the first tank and the second tank, and any combination may be adopted.

As described above, in the chemical module 7 according to the embodiments, each of the first tank and the second tank is any one of a chemical liquid tank for treating the substrate 4 with a chemical liquid, a cleaning tank for cleaning the substrate 4, and a one-bath treatment tank having a function of treating the substrate 4 with a chemical liquid and a function of cleaning the substrate 4. According to such a configuration, the first tank and the second tank can be variously combined.

Note that by appropriately combining arbitrary embodiments and modifications among the various embodiments and modifications described above, the effects of the respective embodiments and modifications can be achieved.

### REFERENCE SIGNS LIST

- 1: substrate processing device
- 2: carrier
- 4: substrate
- 7: chemical module
- 32: chemical liquid tank
- 34: cleaning tank
- 70: first conveyance mechanism
- 72: second conveyance mechanism
- LV1: first region
- LV2: second region
- LV3: third region

## Claims

1. A substrate processing module comprising:
a first tank and a second tank that are arranged in a first direction and in which a substrate can be disposed;
a first conveyance mechanism that moves the substrate in the first direction; and
a second conveyance mechanism that moves the substrate in a second direction intersecting the first direction,
wherein
the first tank and the second tank are disposed in a first region,
the first conveyance mechanism conveys the substrate in the first direction in a second region disposed above the first region, and
the second conveyance mechanism conveys the substrate in the second direction in a third region different from the second region.

2. The substrate processing module according to claim 1, wherein the first region, the second region, and the third region are disposed in this order from a bottom in a vertical direction.

3. The substrate processing module according to claim 2, wherein
the first conveyance mechanism includes a first vertical actuator that vertically moves the substrate between the first region and the second region, and
the second conveyance mechanism includes a second vertical actuator that vertically moves the substrate between the second region and the third region.

4. The substrate processing module according to claim 3, wherein the first vertical actuator is disposed at a position shifted in the second direction with respect to the first tank and the second tank and disposed at a height position lower than the second region.

5. The substrate processing module according to claim 1, further comprising a controller,
wherein the controller controls the first conveyance mechanism and the second conveyance mechanism to transfer the substrate with each other in the second region.

6. The substrate processing module according to claim 5, wherein the controller controls the second conveyance mechanism to selectively execute a first function of conveying the substrate in the second direction in the second region and a second function of conveying the substrate in the second direction in the third region.

7. The substrate processing module according to claim 2, wherein a movement range of the substrate in the first direction by the first conveyance mechanism and a movement range of the substrate in the second direction by the second conveyance mechanism at least partially overlap each other in plan view.

8. The substrate processing module according to claim 1, wherein
the first conveyance mechanism includes two of the first conveyance sections,
one of the first conveyance sections includes a first chuck that is movable vertically and is disposed in the first tank in a state of holding a substrate,
another of the first conveyance sections includes a second chuck that is movable vertically and is disposed in the second tank in a state of holding a substrate,
at least one of the first chuck and the second chuck is movable between an upper position of the first tank and an upper position of the second tank, and
the first chuck and the second chuck are configured to be able to transfer a substrate to each other.

9. The substrate processing module according to claim 1, wherein the first tank is disposed on a front side in the first direction, the second tank is disposed on a rear side in the first direction, and the second conveyance mechanism moves the substrate above the first tank.

10. The substrate processing module according to claim 1, wherein each of the first tank and the second tank is any one of a chemical liquid tank that treats the substrate with chemical liquid, a cleaning tank that cleans the substrate, and a one-bath treatment tank having a function of treating the substrate with chemical liquid and a function of cleaning the substrate.

11. The substrate processing module according to claim 10, wherein the first tank is a cleaning tank disposed on a front side in the first direction, and the second tank is a chemical liquid tank disposed on a rear side in the first direction.

12. The substrate processing module according to claim 1, wherein
the substrate processing module can be coupled to another module in the second direction, and
the another module is any one of a loading module, an unloading module, a drying module, and a substrate processing module.

13. The substrate processing module according to claim 1, wherein the first conveyance mechanism or the second conveyance mechanism includes a position adjustment mechanism that adjusts a position of holding the substrate.

14. The substrate processing module according to claim 13, wherein the position adjustment mechanism has a function of adjusting a conveyance position of the substrate in the first direction.

15. A substrate processing device comprising:
the substrate processing module according to any one of claims 1 to 14; and
another module coupled to the substrate processing module in the second direction.
